# EUROPEAN PATENT APPLICATION

(11) **EP 4 333 285 A1**
(43) Date of publication of application: **06.03.2024**
(21) Application number: 21943378.6
(22) Date of filing: 31.05.2021
(51) Int. Cl.: H02M 3/155, G06F 1/26, H03F 1/00, G05F 1/66

(54) **POWER CIRCUIT AND ELECTRONIC DEVICE**

(71) Applicant: Huawei Technologies Co., Ltd., Longgang Shenzhen, Guangdong 518129 (CN)
(72) Inventor: QIN, Xi, Shenzhen, Guangdong 518129 (CN)
(74) Representative: MERH-IP Matias Erny Reichl Hoffmann Patentanwälte PartG mbB
(86) International application number: PCT/CN2021/097147
(87) International publication number: WO 2022/251997

(57) **Abstract**

A power circuit (A) and an electronic device are provided. The power circuit (A) includes a power module (A1) and a power feeding module (A2) coupled to the power module (A1). The power module (A1) is configured to supply power in a time-slice power-on manner. This avoids impact of the power circuit (A) and the electronic device at a switch-on or switch-off moment on a power supply, improves stability of the power supply and reliability of the power circuit (A), reduces a size of the power circuit (A), and reduces costs of the power circuit (A).

## Description

### TECHNICAL FIELD

This application relates to the field of power electronics technologies, and more specifically, to a power circuit and an electronic device.

### BACKGROUND

A power circuit (for example, a power amplifier circuit, a digital-to-analog conversion circuit, or a charging circuit) in a communication system, a radar system, or the like usually needs to be switched on or off at specific time according to a protocol or based on an application requirement. Switching on or off the power circuit causes a large voltage fluctuation of a power supply and accelerates aging of a component (for example, a power transistor) in the power circuit. This affects reliability and service life of the power circuit.

Therefore, a technical solution that can effectively control a voltage fluctuation of the power supply is urgently needed.

### SUMMARY

Embodiments of this application provide a power circuit and an electronic device, so that a voltage of a power supply can slowly increase or decrease during switching on or off of the power circuit and the electronic device, to reduce impact of the power circuit and the electronic device on the power supply, effectively control a voltage fluctuation of the power supply, and improve stability of the power supply.

According to a first aspect, an embodiment of this application provides a power circuit. The power circuit may be a circuit, for example, a power amplifier circuit or a digital-to-analog conversion circuit, that can enable a voltage of a power supply to slowly increase or decrease during switching on or off of the power circuit. A specific form of the power circuit is not limited in this embodiment of this application.

In a possible implementation, the power circuit provided in this embodiment of this application may include a power module and a power feeding module coupled to the power module. The power module is configured to supply power in a time-slice power-on manner.

Further, supplying power in the time-slice power-on manner by the power module may include but is not limited to the following two cases:

Case 1: The power feeding module supplies power to the power module in the time-slice power-on manner.

It should be noted that the power feeding module may provide a feeding current for the power module in the time-slice power-on manner, or the power feeding module may provide a feeding voltage for the power module in the time-slice power-on manner. The feeding current indicates an output current of the power feeding module, and the feeding voltage indicates an output voltage of the power feeding module.

It may be understood that after the power feeding module supplies power to the power module in the time-slice power-on manner, the power module is configured to implement power-on based on the feeding current or the feeding voltage provided by the power feeding module. In other words, the power module controls a static operating current of the power module based on the feeding current or the feeding voltage provided by the power feeding module.

Case 2: On the basis of supplying power by the power feeding module, the power module implements power-on in the time-slice power-on manner.

It should be noted that supplying power by the power feeding module may be that the power feeding module provides a feeding current (where for the feeding current, refer to the foregoing descriptions) for the power module, or may be that the power feeding module provides a feeding voltage (where for the feeding voltage, refer to the foregoing descriptions) for the power module.

It may be understood that based on the feeding current or the feeding voltage provided by the power feeding module, the power module implements power-on in the time-slice power-on manner. In other words, the power module controls a static operating current of the power module based on the feeding current or the feeding voltage provided by the power feeding module.

The power circuit provided in this embodiment of this application supplies power in the time-slice power-on manner by using the power module, to enable a voltage of the power supply to slowly increase during switching on of the power circuit, reduce impact of the power module (in other words, the power circuit) at a switch-on moment of the power module on the power supply, and improve stability of the power supply. In addition, in the time-slice power-on manner, reliability of the power circuit is improved, and costs of the power circuit is reduced.

It should be noted that the power circuit provided in this embodiment of this application may further stop supplying power in a time-slice power-off manner by using the power module, to enable the voltage of the power supply to slowly decrease during switching off of the power circuit, reduce impact of the power module (in other words, the power circuit) at a switch-off moment of the power module on the power supply, and improve stability of the power supply. In addition, in the time-slice power-off manner, the reliability of the power circuit can also be improved, a size of the power circuit can be reduced, and costs of the power circuit can be reduced.

In a possible implementation, the power feeding module includes a plurality of power feeding subunits, the plurality of power feeding subunits are coupled to respective control signal cables, and a delay unit is coupled between the control signal cables. The control signal cable controls the power feeding module to supply power to the power module in the time-slice power-on manner based on a delay set by the delay unit.

In a possible implementation, the power module may include a plurality of power subunits, and the power feeding module is configured to supply power to the plurality of power subunits in the time-slice power-on manner.

In a possible implementation, the power feeding subunit may include a current source unit, where the current source unit includes one current source. The current source is configured to supply power to the power module in the time-slice power-on manner. In other words, the current source provides the feeding current for the power module in the time-slice power-on manner. It may be understood as herein: The current source in the current source unit has a timing control function.

In another possible implementation, the power feeding subunit may include a current source unit and a switch unit, where the current source unit includes a plurality of current sources, the switch unit includes a plurality of switches, and the plurality of current sources are coupled to the plurality of switches in one-to-one correspondence.

Further, the plurality of switches are configured to control, based on a control signal provided by the control signal cable, the plurality of current sources to supply power to the power module. In other words, the plurality of switches control, based on the control signal provided by the control signal cable, the plurality of current sources to provide the feeding current for the power module.

It should be noted that in the foregoing two possible implementations, a feeding current that slowly changes may be provided for the power module by using one current source that has the timing control function in the current source unit or the plurality of current sources in the current source unit and the plurality of switches.

In a possible implementation, the power feeding subunit may include a voltage source unit, where the voltage source unit includes one voltage source. The voltage source is configured to supply power to the power module based on the control signal provided by the control signal cable. In other words, the voltage source provides the feeding voltage to the power module based on the control signal provided by the control signal cable.

In a possible implementation, the power feeding module may further include a bias unit, where an input end of the bias unit is coupled to output ends of the plurality of power feeding subunits, and an output end of the bias unit is coupled to an input end of the power module.

Further, the power feeding subunit is further configured to supply the feeding current to the bias unit. The bias unit is configured to provide the feeding voltage for the power module based on the feeding current.

For example, the bias unit may include any one of a transistor, a field effect transistor, and an IGBT (insulated gate bipolar transistor, that is, insulated gate bipolar transistor).

The bias unit may obtain the feeding voltage based on the feeding current output by the current source, and provide the feeding voltage for the power module, to control the static operating current of the power module by using the feeding voltage, in other words, to control the static operating current of the power module by using the feeding voltage from the bias unit.

In a possible implementation, the power module may include the plurality of power subunits, and the power feeding module is configured to supply power to the plurality of power subunits in the time-slice power-on manner.

In a possible implementation, the power subunit includes one power transistor and one load impedance. A control electrode of the power transistor is coupled to an output end of the power feeding module, a first electrode of the power transistor is coupled to a power supply end by using the load impedance, and a second electrode of the power transistor is coupled to a ground end.

In an example, the power transistor may be the transistor. A base of the transistor is coupled to the output end of the power feeding module by using a corresponding first switch, a collector of the transistor is coupled to the power supply end by using the load impedance, and an emitter of the transistor is coupled to the ground end.

In another example, the power transistor may be the field effect transistor. A gate of the field effect transistor is coupled to the output end of the power feeding module by using a corresponding first switch, a drain of the field effect transistor is coupled to the power supply end by using the load impedance, and a source of the field effect transistor is coupled to the ground end.

In a possible implementation, the power subunit includes a plurality of power transistors, a plurality of first switches, and a load impedance, where the plurality of power transistors and the plurality of first switches are in one-to-one correspondence. A control electrode of the power transistor is coupled to the output end of the power feeding module by using a corresponding first switch, a first electrode of the power transistor is coupled to the power supply end by using the load impedance, and a second electrode of the power transistor is coupled to the ground end.

In an example, the power transistor may be the transistor. A base of the transistor is coupled to the output end of the power feeding module by using a corresponding first switch, a collector of the transistor is coupled to the power supply end by using the load impedance, and an emitter of the transistor is coupled to the ground end.

In another example, the power transistor may be the field effect transistor. A gate of the field effect transistor is coupled to the output end of the power feeding module by using a corresponding first switch, a drain of the field effect transistor is coupled to the power supply end by using the load impedance, and a source of the field effect transistor is coupled to the ground end.

In another possible implementation, the power subunit includes a plurality of power transistors, a plurality of second switches, and a load impedance, where the plurality of power transistors and the plurality of second switches are in one-to-one correspondence. A control electrode of the power transistor is coupled to the output end of the power feeding module, a first electrode of the power transistor is coupled to the power supply end by using the load impedance and a corresponding second switch, and a second electrode of the power transistor is coupled to the ground end.

In an example, the power transistor may be the transistor. A base of the transistor is coupled to the output end of the power feeding module, a collector of the transistor is coupled to the power supply end by using the load impedance and a corresponding second switch, and an emitter of the transistor is coupled to the ground end.

In another example, the power transistor may be the field effect transistor. A gate of the field effect transistor is coupled to the output end of the power feeding module, a drain of the field effect transistor is coupled to the power supply end by using the load impedance and a corresponding second switch, and a source of the field effect transistor is coupled to the ground end.

In another possible implementation, the power subunit includes a plurality of power transistors, a plurality of first switches, a plurality of second switches, and a load impedance, where the plurality of power transistors, the plurality of first switches, and the plurality of second switches are in one-to-one correspondence. A control electrode of the power transistor is coupled to the output end of the power feeding module by using a corresponding first switch, a first electrode of the power transistor is coupled to the power supply end by using the load impedance and a corresponding second switch, and a second electrode of the power transistor is coupled to the ground end.

In an example, the power transistor may be the transistor. A base of the transistor is coupled to the output end of the power feeding module by using a corresponding first switch, a collector of the transistor is coupled to the power supply end by using the load impedance and a corresponding second switch, and an emitter of the transistor is coupled to the ground end.

In another example, the power transistor may be the field effect transistor. A gate of the field effect transistor is coupled to the output end of the power feeding module by using a corresponding first switch, a drain of the field effect transistor is coupled to the power supply end by using the load impedance and a corresponding second switch, and a source of the field effect transistor is coupled to the ground end.

It should be noted that the power subunit in this embodiment of this application is not limited to the foregoing four possible implementations (in other words, the power subunit is not limited to the foregoing four topology structures). Alternatively, the power subunit may control the static operating current of the power module based on the feeding current by using another topology. This is not limited in this embodiment of this application.

In a possible implementation, the power subunit further includes one direct current blocking capacitor and one bias inductor.

The direct current blocking capacitor is disposed between the control electrode of the power transistor and a connected signal source, and the bias inductor is disposed between the control electrode of the power transistor and a bias unit of the power feeding module.

In another possible implementation, the power subunit further includes a plurality of direct current blocking capacitors and a plurality of bias inductors, where the plurality of direct current blocking capacitors, the plurality of bias inductors, and the plurality of power transistors are in one-to-one correspondence.

One end of the direct current blocking capacitor is coupled to a signal source, the other end of the direct current blocking capacitor is coupled to the control electrode of the power transistor, one end of the bias inductor is coupled to the bias unit of the power feeding module, and the other end of the bias inductor is coupled to the control electrode of the power transistor.

The direct current blocking capacitor plays a role of isolating a direct current signal from passing through an alternate current signal. The bias inductor plays a role of isolating a high-frequency signal from passing through a low-frequency signal. A modulation signal (which may be a monophonic signal or a high-frequency alternate signal, for example, a high-frequency amplitude signal or a high-frequency phase signal) from the signal source and a low-frequency voltage signal from the bias unit may be input to the power module. This improves quality of a signal (including the modulation signal from the signal source and the low-frequency voltage signal from the bias unit) input to the power module.

In a possible implementation, the power module may be a power amplifier PA (power amplifier), and is configured to work in a transmit slot in a time division duplex TDD (time division duplex) mode.

In another possible implementation, the power module may be a low noise amplifier LNA (low noise amplifier), and is configured to work in a receive slot in a time division duplex TDD mode.

According to a second aspect, an embodiment of this application provides a power circuit. The power circuit may be a circuit, for example, a power amplifier circuit or a digital-to-analog conversion circuit, that can enable a voltage of a power supply to slowly increase or decrease during switching on or off of the power circuit. A specific form of the power circuit is not limited in this embodiment of this application.

In a possible implementation, the power circuit provided in this embodiment of this application may include a power module and a power feeding module coupled to the power module, where the power feeding module may include a plurality of power feeding subunits. The plurality of power feeding subunits separately include a respective control signal cable, configured to control the power feeding module to supply power to the power module.

It should be noted that the plurality of power feeding subunits supply power to the power module by using the respective control signal cable. The plurality of power feeding subunits may provide a feeding current for the power module, or the plurality of power feeding subunits may provide a feeding voltage for the power module. The feeding current indicates output currents of the plurality of power feeding subunits, and the feeding voltage indicates output voltages of the plurality of power feeding subunits.

It may be understood that after the plurality of power feeding subunits supply power to the power module, the power module is configured to control a static operating current of the power module based on the feeding current or the feeding voltage provided by the power feeding module.

The power circuit provided in this embodiment of this application supplies power to the power module by using the plurality of power feeding subunits in the power feeding module. This reduces impact of the power module (in other words, the power circuit) at a switch-on moment on the power supply, and improves stability of the power supply. In addition, this improves reliability of the power circuit, reduces a size of the power circuit, and reduces costs of the power circuit.

It should be noted that the power circuit provided in this embodiment of this application may further successively stop supplying power to the power module by using the plurality of power feeding subunits in the power feeding module. This reduces impact of the power module (in other words, the power circuit) at a switch-off moment on the power supply, and improves the stability of the power supply. In addition, this improves the reliability of the power circuit, reduces the size of the power circuit, and reduces the costs of the power circuit.

Optionally, a delay unit is coupled between control signal cables. A delay interval set by the delay unit enables the power feeding module to supply power to the power module in a time-slice power-on manner.

In a possible implementation, the power feeding subunit may include a current source unit, where the current source unit includes one current source. The current source is configured to supply power to the power module by controlling a control signal cable of the current source. In other words, the current source provides the feeding current to the power module by controlling the control signal cable of the current source. It may be understood as herein: The current source in the current source unit has a timing control function.

In another possible implementation, the power feeding subunit may include a current source unit and a switch unit, where the current source unit includes a plurality of current sources, the switch unit includes a plurality of switches, and the plurality of current sources are coupled to the plurality of switches in one-to-one correspondence.

Further, the plurality of switches are configured to control, based on a control signal provided by the control signal cable, the plurality of current sources to supply power to the power module. In other words, the plurality of switches control, based on the control signal provided by the control signal cable, the plurality of current sources to provide the feeding current for the power module.

It should be noted that in the foregoing two possible implementations, a feeding current that slowly changes may be provided for the power module by using one current source that has the timing control function in the current source unit or the plurality of current sources in the current source unit and the plurality of switches.

In a possible implementation, the power feeding subunit may include a voltage source unit, where the voltage source unit includes one voltage source. The voltage source is configured to supply power to the power module based on the control signal provided by the control signal cable. In other words, the voltage source provides the feeding voltage to the power module based on the control signal provided by the control signal cable.

In a possible implementation, the power feeding module may further include a bias unit, where an input end of the bias unit is coupled to output ends of the plurality of power feeding subunits, and an output end of the bias unit is coupled to an input end of the power module.

Further, the power feeding subunit is further configured to supply the feeding current to the bias unit based on the control signal cable. The bias unit is configured to provide the feeding voltage for the power module based on the feeding current.

For example, the bias unit may include any one of a transistor, a field effect transistor, and an IGBT.

The bias unit may obtain the feeding voltage based on the feeding current output by the current source, and provide the feeding voltage for the power module, to control the static operating current of the power module by using the feeding voltage, in other words, to control the static operating current of the power module by using the feeding voltage from the bias unit.

In a possible implementation, the power module may include a plurality of power subunits, and the power feeding module is configured to separately supply power to the plurality of power subunits.

In a possible implementation, the power subunit includes one power transistor and one load impedance. A control electrode of the power transistor is coupled to an output end of the power feeding module, a first electrode of the power transistor is coupled to the power supply end by using the load impedance, and a second electrode of the power transistor is coupled to a ground end.

In an example, the power transistor may be the transistor. A base of the transistor is coupled to the output end of the power feeding module by using a corresponding first switch, a collector of the transistor is coupled to the power supply end by using the load impedance, and an emitter of the transistor is coupled to the ground end.

In another example, the power transistor may be the field effect transistor. A gate of the field effect transistor is coupled to the output end of the power feeding module by using a corresponding first switch, a drain of the field effect transistor is coupled to the power supply end by using the load impedance, and a source of the field effect transistor is coupled to the ground end.

In a possible implementation, the power subunit includes a plurality of power transistors, a plurality of first switches, and a load impedance, where the plurality of power transistors and the plurality of first switches are in one-to-one correspondence. A control electrode of the power transistor is coupled to the output end of the power feeding module by using a corresponding first switch, a first electrode of the power transistor is coupled to the power supply end by using the load impedance, and a second electrode of the power transistor is coupled to the ground end.

In an example, the power transistor may be the transistor. A base of the transistor is coupled to the output end of the power feeding module by using a corresponding first switch, a collector of the transistor is coupled to the power supply end by using the load impedance, and an emitter of the transistor is coupled to the ground end.

In another example, the power transistor may be the field effect transistor. A gate of the field effect transistor is coupled to the output end of the power feeding module by using a corresponding first switch, a drain of the field effect transistor is coupled to the power supply end by using the load impedance, and a source of the field effect transistor is coupled to the ground end.

In another possible implementation, the power subunit includes a plurality of power transistors, a plurality of second switches, and a load impedance, where the plurality of power transistors and the plurality of second switches are in one-to-one correspondence. A control electrode of the power transistor is coupled to the output end of the power feeding module, a first electrode of the power transistor is coupled to the power supply end by using the load impedance and a corresponding second switch, and a second electrode of the power transistor is coupled to the ground end.

In an example, the power transistor may be the transistor. A base of the transistor is coupled to the output end of the power feeding module, a collector of the transistor is coupled to the power supply end by using the load impedance and a corresponding second switch, and an emitter of the transistor is coupled to the ground end.

In another example, the power transistor may be the field effect transistor. A gate of the field effect transistor is coupled to the output end of the power feeding module, a drain of the field effect transistor is coupled to the power supply end by using the load impedance and a corresponding second switch, and a source of the field effect transistor is coupled to the ground end.

In another possible implementation, the power subunit includes a plurality of power transistors, a plurality of first switches, a plurality of second switches, and a load impedance, where the plurality of power transistors, the plurality of first switches, and the plurality of second switches are in one-to-one correspondence. A control electrode of the power transistor is coupled to the output end of the power feeding module by using a corresponding first switch, a first electrode of the power transistor is coupled to the power supply end by using the load impedance and a corresponding second switch, and a second electrode of the power transistor is coupled to the ground end.

In an example, the power transistor may be the transistor. A base of the transistor is coupled to the output end of the power feeding module by using a corresponding first switch, a collector of the transistor is coupled to the power supply end by using the load impedance and a corresponding second switch, and an emitter of the transistor is coupled to the ground end.

In another example, the power transistor may be the field effect transistor. A gate of the field effect transistor is coupled to the output end of the power feeding module by using a corresponding first switch, a drain of the field effect transistor is coupled to the power supply end by using the load impedance and a corresponding second switch, and a source of the field effect transistor is coupled to the ground end.

It should be noted that the power subunit in this embodiment of this application is not limited to the foregoing four possible implementations (in other words, the power subunit is not limited to the foregoing four topology structures). Alternatively, the power subunit may control the static operating current of the power module based on the feeding current by using another topology. This is not limited in this embodiment of this application.

In a possible implementation, the power subunit further includes one direct current blocking capacitor and one bias inductor.

The direct current blocking capacitor is disposed between the control electrode of the power transistor and a connected signal source, and the bias inductor is disposed between the control electrode of the power transistor and a bias unit of the power feeding module.

In another possible implementation, the power subunit further includes a plurality of direct current blocking capacitors and a plurality of bias inductors, where the plurality of direct current blocking capacitors and the plurality of bias inductors are in one-to-one correspondence with a plurality of power transistors.

One end of the direct current blocking capacitor is coupled to a signal source, the other end of the direct current blocking capacitor is coupled to the control electrode of the power transistor, one end of the bias inductor is coupled to the bias unit of the power feeding module, and the other end of the bias inductor is coupled to the control electrode of the power transistor.

The direct current blocking capacitor plays a role of isolating a direct current signal from passing through an alternate current signal. The bias inductor plays a role of isolating a high-frequency signal from passing through a low-frequency signal. A modulation signal (which may be a monophonic signal or a high-frequency alternate signal, for example, a high-frequency amplitude signal or a high-frequency phase signal) from the signal source and a low-frequency voltage signal from the bias unit may be input to the power module. This improves quality of a signal (including the modulation signal from the signal source and the low-frequency voltage signal from the bias unit) input to the power module.

In a possible implementation, the power module may be a power amplifier PA, and is configured to work in a transmit slot in a time division duplex TDD mode.

In another possible implementation, the power module may be a low noise amplifier LNA, and is configured to work in a receive slot in a time division duplex TDD mode.

According to a third aspect, an embodiment of this application further provides an electronic device. The electronic device may include a plurality of the power circuits in the first aspect and possible implementations of the first aspect, or may include a plurality of the power circuits in the second aspect and possible implementations of the second aspect. The plurality of the power circuits are coupled in a series manner or in a parallel manner.

In a possible implementation, the electronic device provided in this embodiment of this application may further include a circuit board. The power circuit is disposed on the circuit board.

It should be understood that the technical solutions in the second aspect and the third aspect of this application are consistent with the technical solutions in the first aspect of this application. Beneficial effects achieved by various aspects and corresponding feasible implementations are similar. Details are not described again.

### BRIEF DESCRIPTION OF DRAWINGS

FIG. 1 is a schematic diagram of a structure of a power circuit A according to an embodiment of this application;
FIG. 2 is a schematic diagram of a structure of a power feeding module A2 according to an embodiment of this application;
FIG. 3 is a schematic diagram of a structure of a current source unit A21 according to an embodiment of this application;
FIG. 4 is a schematic diagram of responding to a delay unit by a driver according to an embodiment of this application;
FIG. 5 is a schematic diagram of a timing according to an embodiment of this application;
FIG. 6 is a schematic diagram of a structure of a current source unit A21 according to an embodiment of this application;
FIG. 7 is a schematic diagram of a structure of a current source unit A21 according to an embodiment of this application;
FIG. 8 is a schematic diagram of a structure of a bias unit A23 according to an embodiment of this application;
FIG. 9 is a schematic diagram of a structure of a power feeding module A2 according to an embodiment of this application;
FIG. 10 is a schematic diagram of a structure of a voltage source unit A22 according to an embodiment of this application;
FIG. 11 is a schematic diagram of a structure of a power module A1 according to an embodiment of this application;
FIG. 12 is a schematic diagram of a structure of a power module A1 according to an embodiment of this application;
FIG. 13 is a schematic diagram of a structure of a power module A1 according to an embodiment of this application;
FIG. 14 is a schematic diagram of a structure of a power module A1 according to an embodiment of this application;
FIG. 15 is a schematic diagram of a structure of a power module A1 according to an embodiment of this application;
FIG. 16 is a schematic diagram of a structure of a power module A1 according to an embodiment of this application;
FIG. 17 is a schematic diagram of a structure of a power module A1 according to an embodiment of this application;
FIG. 18 is a schematic diagram of a structure of a power module A1 according to an embodiment of this application;
FIG. 19 is a schematic diagram of a structure of a power module A1 according to an embodiment of this application;
FIG. 20 is a schematic diagram of a structure of a power module A1 according to an embodiment of this application;
FIG. 21 is a schematic diagram of a structure of a power module A1 according to an embodiment of this application;
FIG. 22 is a schematic diagram of a structure of a power module A1 according to an embodiment of this application;
FIG. 23 is a schematic diagram of a structure of a power module A1 according to an embodiment of this application;
FIG. 24 is a schematic diagram of a structure of a power module A1 according to an embodiment of this application;
FIG. 25 is a schematic diagram of a structure of a power module A1 according to an embodiment of this application;
FIG. 26 is a schematic diagram of a structure of a power circuit A according to an embodiment of this application;
FIG. 27 is a schematic diagram of a structure of a power circuit A according to an embodiment of this application;
FIG. 28 is a schematic diagram of a structure of a power circuit A according to an embodiment of this application;
FIG. 29 is a schematic diagram of a structure of an electronic device EE according to an embodiment of this application;
FIG. 30 is a schematic diagram of a structure of an electronic device EE according to an embodiment of this application;
FIG. 31 is a schematic diagram of a timing according to an embodiment of this application;
FIG. 32 is a schematic diagram of a structure of an electronic device EE according to an embodiment of this application;
FIG. 33 is a schematic diagram of a structure of an electronic device EE according to an embodiment of this application; and
FIG. 34 is a schematic diagram of a structure of an electronic device EE according to an embodiment of this application.

### DESCRIPTION OF EMBODIMENTS

The following describes the technical solutions of this application with reference to the accompanying drawings.

To make the objectives, technical solutions, and advantages of this application clearer, the following clearly and completely describes the technical solutions of this application with reference to the accompanying drawings of this application. It is clear that the described embodiments are merely a part rather than all of embodiments of this application. All other embodiments obtained by a person of ordinary skill in the art based on embodiments of this application without creative efforts shall fall within the protection scope of this application.

In this specification of this application, the terms "first", "second", and the like of the embodiments, claims, and accompanying drawings are merely intended for distinguishing and description, but cannot be understood as an indication or implication of relative importance, or cannot be understood as an indication or implication of an order. In addition, the terms "include", "have", and any variant thereof are intended to cover non-exclusive inclusion, for example, include a series of steps or units. Methods, systems, products, or devices are not necessarily limited to those steps or units that are literally listed, but may include other steps or units that are not literally listed or that are inherent to such processes, methods, products, or devices.

It should be understood that in this application, "at least one (item)" refers to one or more, and "a plurality of" refers to two or more than two. "And/or" is used for describing an association relationship between associated objects, and represents that three relationships may exist. For example, "A and/or B" may represent the following three cases: Only A exists, only B exists, and both A and B exist, where A and B may be singular or plural. The character "/" usually indicates an "or" relationship between the associated objects. "At least one of the following items (pieces)" or a similar expression thereof indicates any combination of the following items, including a single item (piece) or any combination of plural items (pieces). For example, at least one item (piece) of a, b, or c may indicate a, b, c, "a and b", "a and c", "b and c", or "a, b, and c", where a, b, and c may be singular or plural.

A power circuit (for example, a power amplifier circuit or a digital-to-analog conversion circuit) in a communication system, a radar system, or the like usually needs to be switched on or off at specific time according to a protocol or based on an application requirement. Switching on or off of the power circuit is accompanied by a sudden change (sudden increase or decrease) of a transient current of a power supply in the power circuit. In combination with a relationship between a voltage of the power supply and the transient current (where the relationship between the voltage and the transient current of the power supply may be expressed as v = *L·di*/*dt,* where v represents the voltage of the power supply, L represents an inductance value of an inductor in the power supply, and *di*/*dt* represents the transient current of the power supply (that is, a current change rate of the power supply)), it can be learned that a sharper sudden change of the transient current indicates a greater voltage fluctuation of the power supply. A voltage fluctuation of the power supply affects performance of the power circuit that is not switched off, and accelerates aging of a component (for example, a power transistor) in the power circuit when the voltage fluctuation exceeds a specific voltage range. This affects reliability and service life of the power circuit.

To effectively control the voltage fluctuation of the power supply, the following two methods are used in embodiments of this application.

Method 1: Increase a capacitance value of a decoupling capacitor without increasing a quantity of decoupling capacitors of the power supply, or increase a quantity of decoupling capacitors without increasing a capacitance value of a decoupling capacitor.

Regardless of increasing the capacitance value of the decoupling capacitor or increasing the quantity of decoupling capacitors, an inductance value of an equivalent inductor in the power supply. It may be determined, based on the relationship between the voltage and the transient current of the power supply v = *L·di*/*dt,* that the inductance value *L* of the inductor is directly proportional to the voltage v of the power supply. In other words, the voltage v decreases as the inductance value L of the inductor decreases.

However, in the method 1, costs of a bill of materials (bill of materials, BOM) and an area of a printed circuit board (printed circuit board, PCB) need to be increased. This results in a large size of the power circuit.

Method 2: Use a large quantity of independent power supplies (that is, sub-power supplies) to supply power to the power circuit.

In a possible implementation, different independent power supplies, for example, a low dropout regulator (low dropout regulator, LDO) or a direct current converter (that is, a DC-DC converter) are used to supply power to the power circuit. In other words, different independent power supplies are used to separately supply power to a module that is susceptible to interference and a module that may cause greater disturbance in the power circuit.

However, in the method 2, because a large quantity of independent power supplies are used, a size of the power circuit is large, and costs of the power circuit are increased.

To overcome disadvantages of the foregoing two methods, an embodiment of this application further provides a power circuit, to enable a voltage (which is determined by the following static operating current, and is directly proportional to the static operating current) of a power supply to slowly change (to be specific, to enable the voltage of the power supply to slowly increase during switching on of the power circuit, or enable the voltage of the power supply to slowly decrease during switching off of the power circuit) during switching on or off of the power circuit. Therefore, impact of the power circuit on the power supply is reduced, a voltage fluctuation of the power supply is effectively controlled, and stability of the power supply is improved.

It should be noted that the power circuit provided in this application may be a circuit, for example, a power amplifier circuit or a digital-to-analog conversion circuit, that can enable the voltage of the power supply to slowly increase or decrease during switching on or off of the power circuit. A specific form of the power circuit is not limited in this embodiment of this application.

The following describes a power circuit provided in an embodiment of this application by using an example in which the current of the power supply slowly increases during switching on of the power circuit.

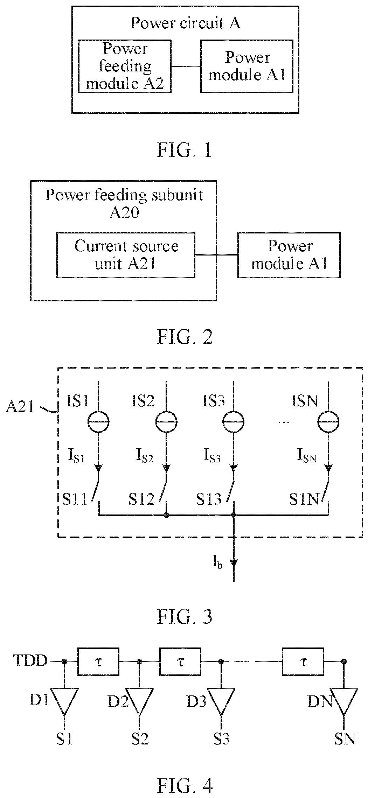

As shown in FIG. 1, a power circuit A may include a power module A1 and a power feeding module A2 coupled to the power module A1. The power module A1 is configured to supply power in a time-slice power-on manner.

Further, supplying power in the time-slice power-on manner by the power module A1 may include but is not limited to the following two cases.

Case 1: The power feeding module A2 supplies power to the power module A1 in the time-slice power-on manner.

It should be noted that, the power feeding module A2 supplying power to the power module A1 in the time-slice power-on manner may be that the power feeding module A2 provides a feeding current (which may be represented as I_{b1}, and may also be referred to as a bias current) or a feeding voltage (which may be represented as V_{bias}, and may also be referred to as a bias voltage) for the power module A1 in the time-slice power-on manner. Herein, the feeding current I_{b1} may indicate an output current of the power feeding module A1, and the feeding voltage V_{bias} may indicate an output voltage of the power feeding module A2. Therefore, it may be understood as: The power feeding module A2 is configured to provide the feeding current I_{b1} or the feeding voltage V_{bias} for the power module A1 in the time-slice power-on manner, and the power module A1 is configured to implement power-on based on the feeding current I_{b1} or the feeding voltage V_{bias} provided by the power feeding module A2. In other words, the power module A1 controls the static operating current (which may be represented as Iₐₘₚ, and may also be referred to as a mirror current) of the power module A1 based on the feeding current I_{b1} or the feeding voltage V_{bias}.

Case 2: On the basis of supplying power by the power feeding module A2, the power module A1 implements power-on in the time-slice power-on manner.

It should be noted that supplying power by the power feeding module A2 may be that the power feeding module A2 provides a feeding current I_{b1} (where for the feeding current, refer to the foregoing descriptions) for the power module A1, or may be that the power feeding module A2 provides a feeding voltage V_{bias} (where for the feeding voltage, refer to the foregoing descriptions) for the power module A1.

It may be understood that based on a feeding current I_{b1} or a feeding voltage V_{bias} provided by the power feeding module A2, the power module A1 implements power-on in the time-slice power-on manner. In other words, the power module A1 controls a static operating current Iₐₘₚ of the power module A1 based on the feeding current I_{b1} or the feeding voltage V_{bias} provided by the power feeding module.

In a possible implementation, the power feeding module A2 may include a plurality of power feeding subunits A20. The plurality of power feeding subunits A20 are all coupled to the power feeding module A2.

In an example, the plurality of power feeding subunits A20 may be coupled to respective control signal cables, and a delay unit is coupled between the plurality of power feeding subunits A20. The control signal cable is configured to control the power feeding module A2 to supply power to the power module A1 in the time-slice power-on manner based on a delay set by the delay unit.

In another example, the plurality of power feeding subunits A20 may separately include a respective control signal cable, configured to control the power feeding module A2 to supply power to the power module A1.

The power circuit provided in this embodiment of this application supplies power in the time-slice power-on manner by using the power module without adding an off-chip component (for example, the decoupling capacitor in the method 1 or the independent power supply in the method 2), to enable the voltage of the power supply to slow increase during switching on of the power circuit, reduce impact of the power module (in other words, the power circuit) at a switch-on moment of the power module on a power supply, and improve stability of the power supply. In addition, in the time-slice power-on manner, reliability of the power circuit is improved, a size of the power circuit is reduced, and costs of the power circuit is reduced.

It should be noted that the power circuit provided in this embodiment of this application may further stop supplying power in a time-slice power-off manner by using the power module, to enable the voltage of the power supply slowly decrease during switching off of the power circuit, reduce impact of the power module (in other words, the power circuit) at a switch-off moment of the power module on the power supply, and improve stability of the power supply. In addition, in the time-slice power-off manner, the reliability of the power circuit can also be improved, the size of the power circuit can be reduced, and costs of the power circuit can be reduced.

In a possible implementation, the power feeding subunit A20 may include a current source unit A21, and the current source unit A21 is coupled to the power module A1, as shown in FIG. 2.

Further, the current source unit A21 may supply power to the power module A1 by using the following two structures. In other words, the current source unit A21 may supply the feeding current I_{b1} to the power module A1 by using the following two structures.

Structure 1-1: As shown in FIG. 3, the current source unit A21 may include N current sources (that is, a current source IS1, a current source IS2, a current source IS3, ..., and a current source ISN) and N switches (that is, a switch S11, a switch S12, a switch S13, ..., and a switch S1N). The N switches are configured to control, based on a control signal provided by the control signal cable, the N current sources to supply power to the power module A1. In other words, the N switches control, based on the control signal provided by the control signal cable, the N current sources to provide the feeding current I_{b1} for the power module A1.

It should be noted that the current source IS 1, the current source IS2, the current source IS3, ..., and the current source ISN have no timing control function. In other words, the current source IS1, the current source IS2, the current source IS3, ..., and the current source ISN have no control function for generation time, stability time, stop time, relationships between the generation time, the stability time, and the stop time, and the like of output currents of the current source IS1, the current source IS2, the current source IS3, ..., and the current source ISN. Therefore, the switch S11, the switch S12, the switch S13, ..., and the switch S1N need to be set.

Optionally, the current source IS1, the current source IS2, the current source IS3, ..., and the current source ISN are coupled to the switch S11, the switch S12, the switch S13, ..., and the switch S1N in one-to-one correspondence. For example, the current source IS1 is correspondingly coupled to the switch S11, the current source IS2 is correspondingly coupled to the switch S12, ..., and the current source ISN is correspondingly coupled to the switch S1N.

It may be understood that the current source IS1, the current source IS2, the current source IS3, ..., and the current source ISN generate output currents of a plurality of current sources. For example, in FIG. 3, the current source IS1 generates an output current Isi of the current source IS1, the current source IS2 generates an output current I_{S2} of the current source IS2, the current source IS3 generates an output current I_{S3} of the current source IS1, ..., and the current source ISN generates an output current I_{SN} of the current source ISN.

Because the current source IS1, the current source IS2, the current source IS3, ..., and the current source ISN have no timing control function, when a power circuit (which may be all components in the power circuit herein, for example, a delay unit, a driver unit, and a current source unit in the power circuit) receives the control signal, for example, a time division duplex (time division duplex, TDD) signal, N drivers (that is, a driver D1, a driver D2, a driver D3, ..., and a driver DN in FIG. 4, the N drivers in total, where the N drivers are coupled to the N switches in one-to-one correspondence) of the power circuit may be used to respectively drive the N switches (for example, the driver D1 drives the switch S11, and the driver D2 drive the switch S12) based on a delay interval (τ in FIG. 4) set by the delay unit, to enable the switch S11, the switch S12, the switch S13, ..., and the switch S1N to be successively turned on based on the delay interval, and slowly increase the feeding current I_{b1}.

Refer to FIG. 3 and FIG. 4. After the current source IS1 to the current source ISN in FIG. 3, and the driver D1 to the driver DN in FIG. 4 receive the time division duplex TDD signal, the current source IS1 generates the output current I_{S1} of the current source IS 1, and the driver D1 directly (that is, without delay interval elapsing) drives the switch S11, to enable the switch S11 to be turned on. In this case, I_{b1} = I_{S1} is met. On a premise that the current source IS1 generates the output current I_{S1} of the current source IS1, and the switch S11 is turned on, the current source IS2 generates the output current I_{S2} of the current source IS2, and the driver D2 drives the switch S12 after the delay interval τ elapses, to enable the switch S12 to be turned on. In this case, I_{b1} = I_{S1} + I_{S2}. Next, on a premise that the current source IS 1 generates the output current I_{S1} of the current source IS1, the current source IS2 generates the output current I_{S2} of the current source IS2, the switch S11 is turned on, and the switch S12 is turned on, the current source IS3 generates an output current I_{S3} of the current source IS3, and the driver D3 drives the switch S13 after the delay interval τ elapses, to enable the switch S13 to be turned on. In this case, I_{b1} = I_{S1} + I_{S2} + I_{S3} is met. By analogy, finally, on a premise that each of the N-1 current sources generates the output current of each current source, the switch S11 to the switch S1 (N-1) are turned on, the current source ISN generates the output current I_{SN} of the current source ISN, and the driver DN drives the switch S1N after the delay interval τ elapses, to enable the switch S1N to be turned on. In this case, I_{b1} = I_{S1} + I_{S2} + I_{S3} + ... + I_{SN} is met.

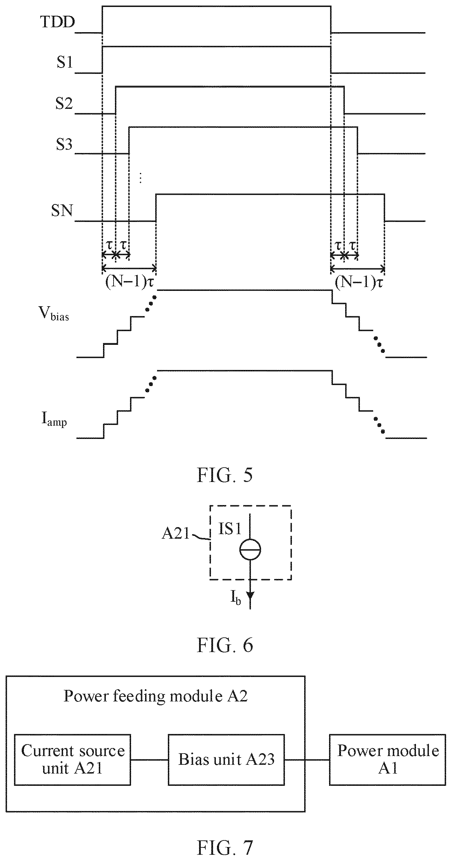

Based on the foregoing descriptions and a schematic diagram of a timing of the time division duplex TDD signal, the switch S1, the switch S2, ..., and the switch SN, the feeding voltage V_{bias}, and the static operating current Iₐₘₚ shown in FIG. 5, it can be learned that based on the delay interval τ, the switch S11 to the switch S1N are successively turned on, and the feeding current I_{b1} provided by the power feeding module A2 slowly increases from I_{S1} to Isi + I_{S2} + I_{S3} + ... + I_{SN}, in other words, the feeding current I_{b1} of the power feeding module slowly increases. Then, the feeding voltage V_{bias} of the power feeding module slowly increases. In addition, the static operating current Iₐₘₚ of the power module slowly increases by using the power module, to reduce the impact of the power module on the power supply, and improve the stability of the power supply.

Structure 1-2: As shown in FIG. 6, the current source unit A21 may include one current source IS1. The current source IS1 is configured to supply power to the power module A1 in the time-slice power-on manner. In other words, the current source IS1 provides the feeding current I_{b1} for the power module A1 in the time-slice power-on manner.

It should be noted that the current source IS1 has the timing control function. In other words, the current source IS1 has the control function for the generation time, the stability time, the stop time, a relationship between the generation time, the stability time, and the stop time, and the like of the output current of the current source IS1. It may be understood that because the current source IS1 has the timing control function, no switch needs to be disposed in the structure 1-2. In this case, the current source IS1 may output, by using the timing control function, the feeding current I_{b1} that slowly increases.

In another possible implementation, the power feeding module A2 may further include a bias unit A23. As shown in FIG. 7, an input end of the bias unit A23 is coupled to an output end of the current source unit A21. The output end of the bias unit A23 is coupled to an input end of the power module A1. The current source unit A21 is further configured to supply the feeding current I_{b1} to the bias unit, and the bias unit A23 is configured to supply the feeding voltage V_{bias} to the power module A1 based on the feeding current I_{b1}.

Further, the bias unit A23 may be any one of a transistor, a field effect transistor (which may be an NMOS (N-metal-oxide-semiconductor) transistor), and an IGBT (insulated gate bipolar transistor, that is, insulated gate bipolar transistor). In an embodiment of this application, the NMOS transistor is used as an example to describe the bias unit A23.

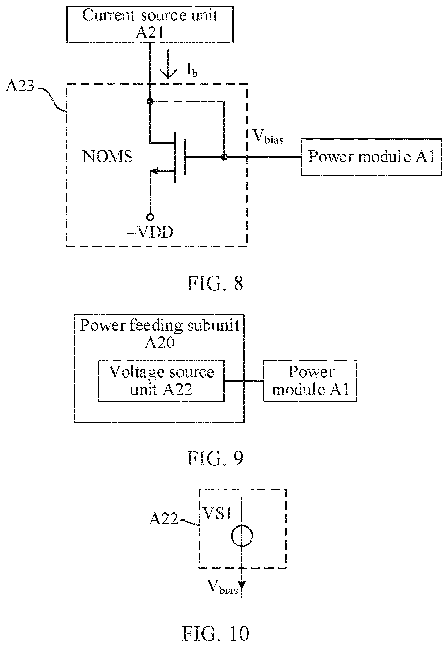

As shown in FIG. 8, the bias unit A23 may include the NMOS transistor. A source s of the NMOS transistor is coupled to -VDD, and a drain d of the NMOS transistor is coupled to the output end of the current source unit A21 (refer to the foregoing descriptions, where the drain d of the NMOS transistor may be coupled to the N switches in the current source unit in the structure 1, or may be coupled to the current source IS1 in the current source unit in the structure 1-2). A gate g of the NMOS transistor is coupled to the drain d, and the gate g of the NMOS transistor is coupled to the input end of the power module A1 (refer to the following descriptions, where the gate g of the NMOS transistor may be coupled to a power transistor in the power module A1 by using a bias inductor in the power module A1, or may be directly coupled to the power transistor in the power module A1, and when an NMOS transistor is used as the power transistor in the power module A1, the gate g of the NMOS transistor in the bias unit A23 is coupled to the gate g of the NMOS transistor in the power module A1 directly or by using the bias inductor, a resistor, or the like).

In another possible implementation, the power feeding subunit A20 may include a voltage source unit A22, and the voltage source unit A22 is coupled to the power module A1, as shown in FIG. 9. The current source unit A21 may provide the feeding voltage V_{bias} for the power module A1 by using a structure shown in FIG. 10.

In FIG. 10, the voltage source unit A22 includes one voltage source VS1. The voltage source VS1 is configured to supply power to the power module A1 based on a control signal provided by a control signal cable. In other words, the voltage source VS1 provides the feeding voltage V_{bias} to the power module A1 based on the control signal provided by the control signal cable.

It should be noted that the voltage source VS1 has a timing control function. In other words, the voltage source VS1 has the control function for generation time, stability time, stop time, a relationship between the generation time, the stability time, and the stop time, and the like of an output current of the voltage source VS1. It may be understood that because the voltage source VS1 has the timing control function, no switch needs to be disposed in the structure 2-1. In this case, the voltage source VS1 may output, by using the timing control function, the feeding voltage V_{bias} that slowly increases.

Further, the power module A1 may include a plurality of power subunits A10. The power feeding module A2 is configured to supply power for the plurality of power subunits A10 in a time-slice power-on manner.

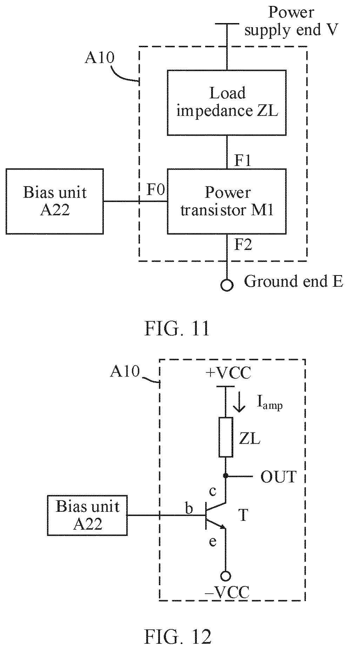

In a possible implementation, the power subunit A10 may include one power transistor M1 and one load impedance ZL, as shown in FIG. 11. In FIG. 11, a control electrode F0 of the power transistor M1 is coupled to the output end of the bias unit A23, a first electrode F1 of the power transistor M1 is coupled to a power supply end V by using the load impedance ZL, and a second electrode F2 of the power transistor M1 is coupled to a ground end E.

Further, the power transistor M1 may be a transistor or a field effect transistor FET (field effect transistor, which may be a junction field effect transistor JFET (junction field effect transistor), or may be an insulated gate field effect transistor (which is also referred to as a MOS transistor)). The power transistor M1 may alternatively be an IGBT (which is obtained by compounding an insulated gate field effect transistor IGFET (insulated gate field effect transistor) and a transistor T (transistor)).

For example, the power transistor M1 is the transistor. As shown in FIG. 12, a base b (that is, the control electrode) of the transistor T is coupled to the output end of the bias unit A23. A collector c (that is, the first electrode) of the transistor T is coupled to +VCC (that is, the power supply end) by using the load impedance ZL. An emitter e (that is, the second electrode) of the transistor T is coupled to -VCC (that is, the ground end, which may alternatively be GND). It should be noted that OUT in FIG. 12 represents the output end of the power subunit A10, and Iₐₘₚ represents a feeding current of the power subunit A10.

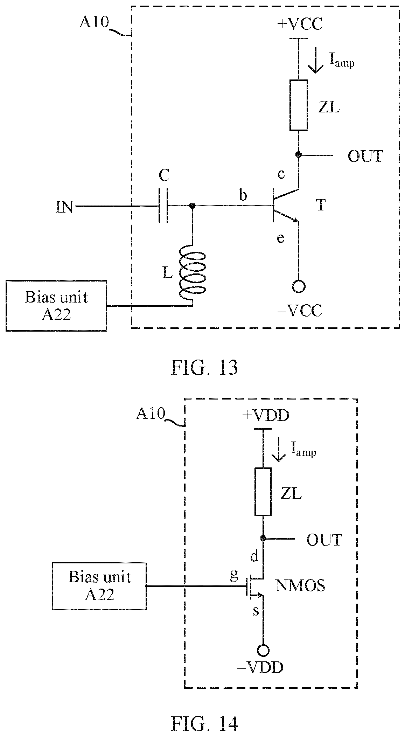

As shown in FIG. 13, based on FIG. 12, the power subunit A10 may further include one direct current blocking capacitor C and one bias inductor L. In FIG. 13, one end of the direct current blocking capacitor C is coupled to a connected signal source IN, and the other end of the direct current blocking capacitor C is coupled to the base b of the transistor T. One end of the bias inductor L is coupled to the bias unit A23, and the other end of the bias inductor L is coupled to the base b of the transistor T. It should be noted that by using the direct current blocking capacitor C (which isolates a direct current signal from passing through an alternate current signal) and the bias inductor L (which isolates a high-frequency signal from passing through a low-frequency signal), a modulation signal (which may be a monophonic signal or a high-frequency alternate signal, for example, a high-frequency amplitude signal or a high-frequency phase signal) from the signal source IN and a low-frequency voltage signal from the bias unit A23 may be input to the power subunit A10.

For another example, the power transistor M1 is the NMOS transistor (where the NMOS transistor is used as an example in this embodiment of this application). As shown in FIG. 14, the gate g (that is, the control electrode) of the NMOS transistor is coupled to the output end of the bias unit A23. The drain d (that is, the first electrode) of the NMOS transistor is coupled to +VDD (that is, the power supply end) by using the load impedance ZL. The source s (that is, the second electrode) of the NMOS transistor is coupled to -VDD (that is, the ground end, which may alternatively be GND).

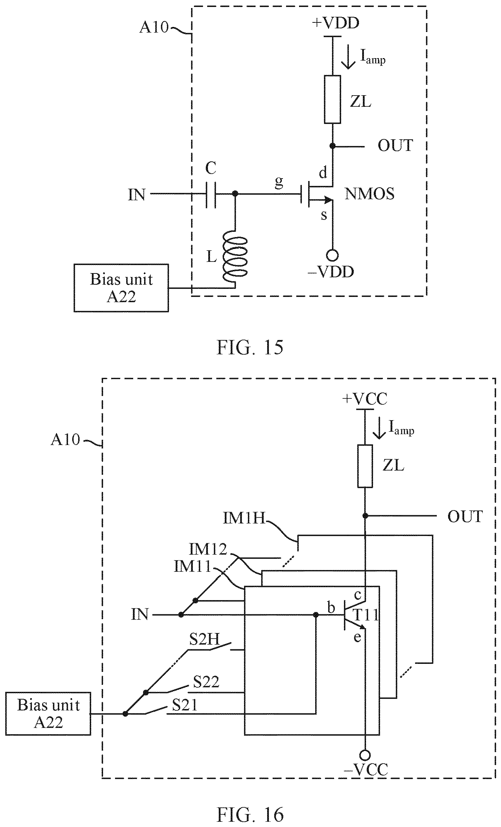

Based on FIG. 14, as shown in FIG. 15, the power subunit A10 may further include one direct current blocking capacitor C (which has a same function as the foregoing direct current blocking capacitor C) and one bias inductor L (which has a same function as the foregoing direct current blocking capacitor C). In FIG. 15, one end of the direct current blocking capacitor C is coupled to the signal source IN, and the other end of the direct current blocking capacitor C is coupled to the gate g of the NMOS transistor. One end of the bias inductor L is coupled to the bias unit A23, and the other end of the bias inductor L is coupled to the gate g of the NMOS transistor.

In another possible implementation, the power subunit A10 may include H power transistors, H switches (that is, H first switches), and a load impedance (where there may be one load impedance, or may be a plurality of load impedances). The H power transistors are coupled to the H switches in one-to-one correspondence.

Further, the H power transistors each may be the transistor or the field effect transistor FET (which may be the junction field effect transistor JFET or the insulated gate field effect transistor (which is also referred to as a MOS transistor)). The H power transistors each may alternatively be the IGBT (which is obtained by compounding the insulated gate field effect transistor IGFET and the transistor).

For example, the H power transistors each are the transistor. The power subunit A10 includes the H transistors, the H first switches (that is, a switch S21, a switch S22, ..., and a switch S2H in FIG. 16) and the load impedance.

As shown in FIG. 16, in this application, one load impedance ZL is used as an example to describe the power subunit A10. Only a transistor T11 is marked in FIG. 16. IM11, IM12, ..., and IM1H in FIG. 16 each are an integration component that integrates a corresponding transistor.

Refer to FIG. 16. A base b (that is, a control electrode) of the transistor T11 is coupled to the output end of the bias unit A23 by using the switch S21 (refer to FIG. 8, where the base b of the transistor T11 may be coupled to the gate g (which may be considered as the output end of the bias unit A23) of the NMOS transistor in the bias unit A23 by using the switch S21). A collector c (that is, a first electrode) of the transistor T11 is coupled to +VCC (that is, the power supply end V) by using the load impedance ZL. An emitter e (that is, a second electrode) of the transistor T11 is coupled to -VCC (that is, the ground end E, which may alternatively be GND). It should be noted that a coupling relationship between a transistor integrated on each of integration components IM12, ..., and IM1H and a corresponding switch (that is, the switch S22 to the switch S2H) in FIG. 16 is similar to a coupling relationship between the transistor T11 and the switch S21. Details are not described in this application.

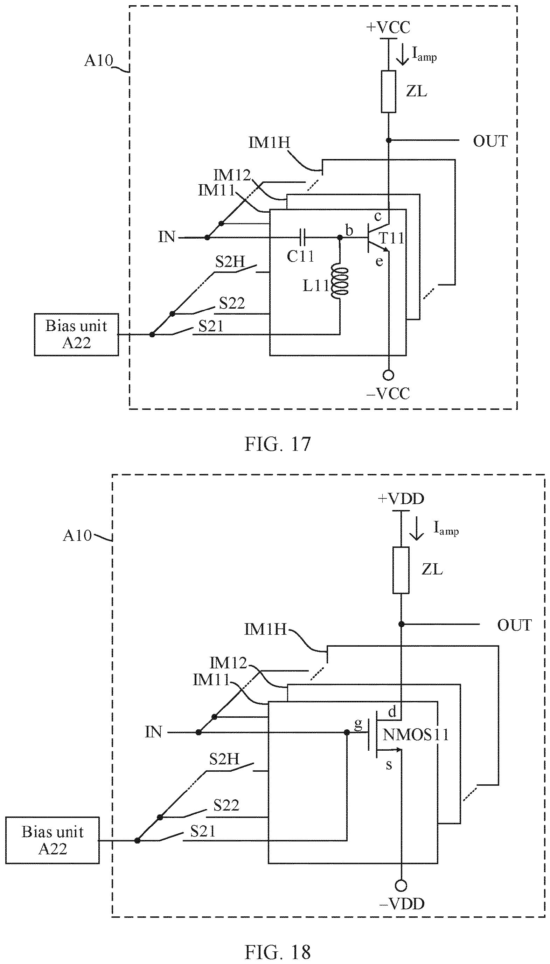

Further, the power subunit A10 may further include H direct current blocking capacitors C (which have a same function as the direct current blocking capacitor C described above) and H bias inductors L (which have a same function as the direct current blocking capacitor C described above). It should be noted that only a direct current blocking capacitor C11 and a bias inductor L11 that are coupled to the base b of the transistor T11 are marked in FIG. 17.

Refer to FIG. 17. One end of the direct current blocking capacitor C11 is coupled to the connected signal source IN, and the other end of the direct current blocking capacitor C11 is coupled to the base b of the transistor T11. One end of the bias inductor L11 is coupled to the bias unit A23, and the other end of the bias inductor L11 is coupled to the base b of the transistor T11. The direct current blocking capacitor C11, the bias inductor L11, and the transistor T11 are integrally disposed on an integration component IM11. It should be noted that coupling relationships between the transistor integrated on each of the integration components IM12, ..., and IM1H, and a corresponding direct current blocking capacitor and a corresponding bias inductor in FIG. 17 are similar to coupling relationships between the transistor T11, and the direct current blocking capacitor C11 and the bias inductor L11. Details are not described in this application. In addition, OUT in FIG. 17 also represents the output end of the power subunit A10, and Iₐₘₚ also represents the feeding current of the power subunit A10.

For another example, as shown in FIG. 18, the H power transistors each are the NMOS transistor. In other words, the power subunit A10 may include H NMOS transistors, the H first switches (that is, the switch S21, the switch S22, ..., and the switch S2H in FIG. 18) and the load impedance ZL.

It should be noted that as shown in FIG. 18, in this application, one load impedance ZL is used as an example to describe the power subunit A10. Only an NMOS11 is marked in FIG. 18. IM11, IM12, ..., and IM1H in FIG. 18 each are an integration component that integrates a corresponding NMOS transistor.

Refer to FIG. 18. A gate g (that is, a control electrode) of the NMOS 11 is coupled to the output end of the bias unit A23 by using the switch S21 (refer to FIG. 8, where the gate g of the NMOS 11 may be coupled to the gate g (which may be considered as the output end of the bias unit A23) of the NMOS transistor in the bias unit A23 by using the switch S21). A drain d (that is, a first electrode) of the NMOS11 is coupled to +VDD (that is, the power supply end V) by using the load impedance ZL. A source s (that is, a second electrode) of the NMOS11 is coupled to - VDD (that is, the ground end E, which may alternatively be GND). It should be noted that a coupling relationship between an NMOS transistor integrated on each of the integration component IM12 to the integration component IM1H and a corresponding switch is similar to a coupling relationship between the NMOS11 and the switch S21. Details are not described in this embodiment of this application. In addition, OUT in FIG. 18 also represents the output end of the power subunit A10, and Iₐₘₚ also represents the feeding current of the power subunit A10.

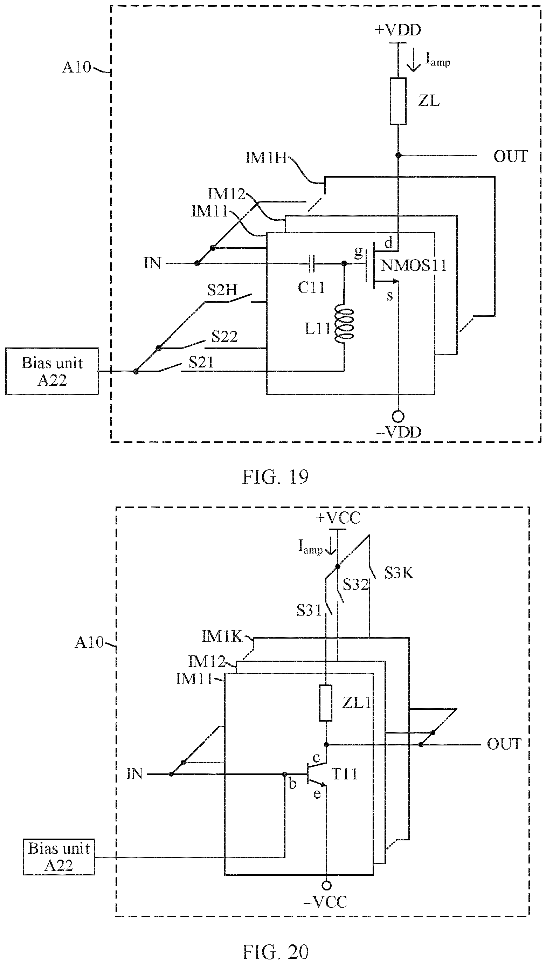

Further, the power subunit A10 may further include the H direct current blocking capacitors C (which have the same function as the direct current blocking capacitor C described above) and the H bias inductors L (which have the same function as the direct current blocking capacitor C described above). It should be noted that only the direct current blocking capacitor C11 and the bias inductor L11 that are coupled to the gate g of the NMOS11 are marked in FIG. 19.

Refer to FIG. 19. One end of the direct current blocking capacitor C11 is coupled to the signal source IN, and the other end of the direct current blocking capacitor C11 is coupled to the gate g of the NMOS 11. One end of the bias inductor L11 is coupled to the bias unit A23 (refer to FIG. 8, where one end of the bias inductor L11 may be coupled to the gate g (which may be considered as the output end of the bias unit A23) of the NMOS transistor in the bias unit A23), and the other end of the bias inductor L11 is coupled to the gate g of the NMOS11. The direct current blocking capacitor C11, the bias inductor L11, and the NMOS11 are integrally disposed on the integration component IM11. It should be noted that the coupling relationships between an NMOS transistor integrated on each of the integration component IM12 to the integration component IM1H, and the corresponding direct current blocking capacitor and the corresponding bias inductor are similar to coupling relationships between the NMOS11, and the direct current blocking capacitor C11 and the bias inductor L11. Details are not described in this embodiment of this application. In addition, OUT in FIG. 19 also represents the output end of the power subunit A10, and Iₐₘₚ also represents the feeding current of the power subunit A10.

In a possible implementation, the power subunit A10 may include K power transistors, K switches (that is, K second switches), and a load impedance (where there may be one load impedance, or may be a plurality of load impedances, and in this embodiment of this application, K load impedances are used as an example). The K power transistors are coupled to the K switches and the K load impedances in one-to-one correspondence.

Further, the K power transistors each may be the transistor or the field effect transistor FET (which may be the junction field effect transistor JFET or the insulated gate field effect transistor (which is also referred to as the MOS transistor)). The K power transistor each may alternatively be the IGBT (which is obtained by compounding the insulated gate field effect transistor IGFET and the transistor).

For example, the K power transistors each are the transistor. In other words, the K power transistors include K transistors, the K second switches (that is, a switch S31, a switch S32, ..., and a switch S3K in FIG. 20), and the H load impedances.

It should be noted that only the transistor T11 and a load impedance ZL1 are marked in FIG. 20. IM11, IM12, ..., and IM1K each are an integration component that integrates a corresponding transistor.

Refer to FIG. 20. The base b (that is, the control electrode) of the transistor T11 is coupled to the output end of the bias unit A23 (refer to FIG. 8, where the base b of the transistor T11 may be coupled to the gate g (which may be considered as the output end of the bias unit A23) of the NMOS transistor in the bias unit A23). The collector c (that is, the first electrode) of the transistor T11 is coupled to +VCC (that is, the power supply end V) by using the load impedance ZL1 and the switch S31. The emitter e (that is, the second electrode) of the transistor T11 is coupled to -VCC (that is, the ground end E, which may alternatively be GND). It should be noted that coupling relationships between a transistor integrated on each of the integration component IM12 to the integration component IM1K, and a corresponding load impedance and a corresponding switch are similar to coupling relationships between the transistor T11, and the load impedance ZL1 and the switch S31. Details are not described in this embodiment of this application. OUT in FIG. 20 also represents the output end of the power subunit A10, and Iₐₘₚ also represents the feeding current of the power subunit A10.

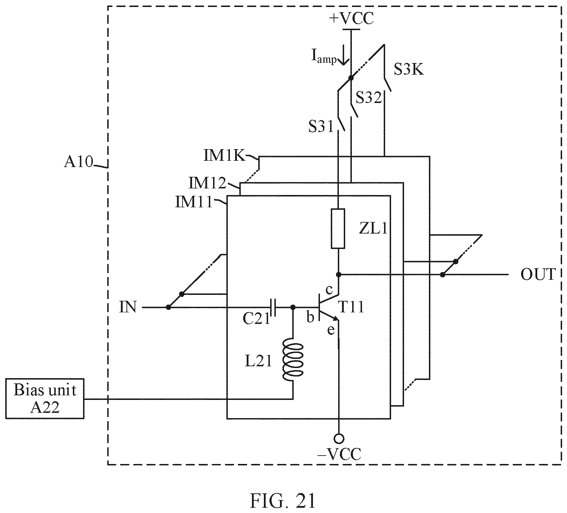

Further, the power subunit A10 may further include K direct current blocking capacitors and K bias inductors. It should be noted that only a direct current blocking capacitor C21 and a bias inductor L21 that are coupled to the base b of the transistor T11 are marked in FIG. 21.

Refer to FIG. 21. One end of the direct current blocking capacitor C21 is coupled to the signal source IN, and the other end of the direct current blocking capacitor C21 is coupled to the base b of the transistor T11. One end of the bias inductor L21 is coupled to the bias unit A23 (refer to FIG. 8, where one end of the bias inductor L11 may be coupled to the gate g (which may be considered as the output end of the bias unit A23) of the NMOS transistor in the bias unit A23), and the other end of the bias inductor L21 is coupled to the base b of the transistor T11. The direct current blocking capacitor C21, the bias inductor L21, and the transistor T11 are integrally disposed on the integration component IM11. It should be noted that the coupling relationships between the transistor integrated on each of the integration component IM12 to the integration component IM1H, and the corresponding direct current blocking capacitor and the corresponding bias inductor are similar to coupling relationships between the NMOS11, and the direct current blocking capacitor C21 and the bias inductor L21. Details are not described in this embodiment of this application. In addition, OUT in FIG. 21 also represents the output end of the power subunit A10, and Iₐₘₚ also represents the feeding current of the power subunit A10.

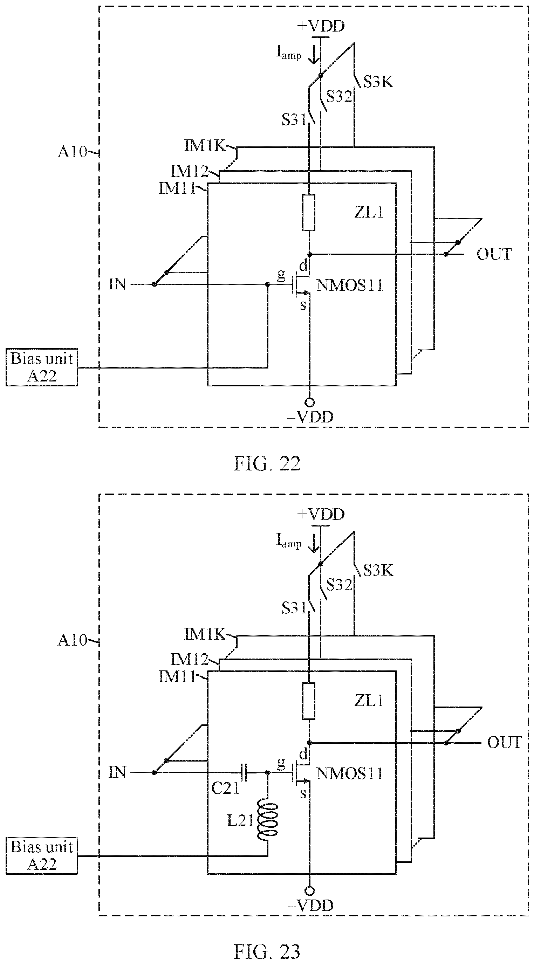

For another example, the K power transistors each are the NMOS transistor. In other words, the power subunit A10 includes K NMOS transistors, the K second switches (that is, the switch S31, the switch S32, ..., and the switch S3K in FIG. 22) and the K load impedances.

It should be noted that only the NMOS11 and the load impedance ZL1 are marked in FIG. 22. IM11, IM12, ..., and IM1K each are the integration component that integrates the corresponding transistor.

Refer to FIG. 22. The gate g (that is, the control electrode) of the NMOS 11 is coupled to the output end of the bias unit A23 (refer to FIG. 8, where the gate g of the NMOS11 may be coupled to the gate g (which may be considered as the output end of the bias unit A23) of the NMOS transistor in the bias unit A23). The drain d (that is, the first electrode) of the NMOS11 is coupled to +VDD (that is, the power supply end V) by using the load impedance ZL1 and the switch S31. The source s (that is, the second electrode) of the NMOS11 is coupled to -VDD (that is, the ground end E, which may alternatively be GND). It should be noted that coupling relationships between the NMOS transistor integrated on each of the integration component IM12 to the integration component IM1K, and a corresponding load impedance and a corresponding switch are similar to coupling relationships between the NMOS11, and the load impedance ZL1 and the switch S31. Details are not described in this embodiment of this application. OUT in FIG. 22 also represents the output end of the power subunit A10, and Iₐₘₚ also represents the feeding current of the power subunit A10.

Further, the power subunit A10 may further include the K direct current blocking capacitors and the K bias inductors. It should be noted that only the direct current blocking capacitor C21 and the bias inductor L21 that are coupled to the gate g of the NMOS11 are marked in FIG. 23.

Refer to FIG. 23. One end of the direct current blocking capacitor C21 is coupled to the signal source IN, and the other end of the direct current blocking capacitor C21 is coupled to the gate g of the NMOS11. One end of the bias inductor L21 is coupled to the bias unit A23 (refer to FIG. 8, where one end of the bias inductor L21 may be coupled to the gate g (which may be considered as the output end of the bias unit A23) of the NMOS transistor in the bias unit A23), and the other end of the bias inductor L21 is coupled to the gate g of the NMOS11. The direct current blocking capacitor C21, the bias inductor L21, and the NMOS11 are integrally disposed on the integration component IM11. It should be noted that coupling relationships between the NMOS transistor integrated on each of the integration component IM12 to the integration component IM1K, and a corresponding direct current blocking capacitor and a corresponding bias inductor are similar to coupling relationships between the NMOS11, and the direct current blocking capacitor C21 and the bias inductor L21. Details are not described in this embodiment of this application. In addition, OUT in FIG. 23 also represents the output end of the power subunit A10, and Iₐₘₚ also represents the feeding current of the power subunit A10.

In another possible implementation, the power subunit A10 may include P power transistors, P first switches, P second switches, and a load impedance (where there may be one load impedance, or may be a plurality of load impedances, and in this embodiment of this application, the plurality of load impedances (that is, P load impedances) are used as an example). The P power transistors are coupled to the P first switches, the P second switches, and the P load impedances in one-to-one correspondence.

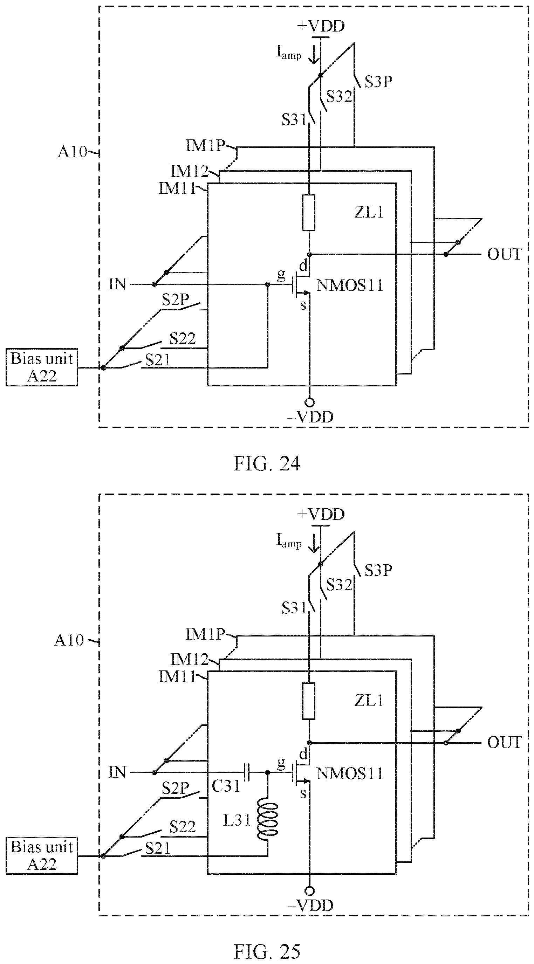

For example, the P power transistors each are the NMOS transistor. In other words, the power subunit A10 includes P NMOS transistors, the P first switches (that is, the switch S21, the switch S22, ..., and a switch S2P in FIG. 24), the P second switches (that is, the switch S31, the switch S32, ..., a switch S3K in FIG. 24), and the P load impedances.

It should be noted that only the NMOS11 and the load impedance ZL1 are marked in FIG. 24. IM11, IM12, ..., and IM1P each are the integration component that integrates the corresponding NMOS transistor.

As shown in FIG. 24, the gate g (that is, the control electrode) of the NMOS11 is coupled to the output end of the bias unit A23 by using the switch S21 (refer to FIG. 8, where the gate g of the NMOS11 may be coupled to the gate g (which may be considered as the output end of the bias unit A23) of the NMOS transistor in the bias unit A23 by using the switch S21). The drain d (that is, the first electrode) of the NMOS11 is coupled to +VDD (that is, the power supply end V) by using the load impedance ZL and the switch S31. The source s (that is, the second electrode) of the NMOS 11 is coupled to -VDD (that is, the ground end E, which may alternatively be GND). It should be noted that coupling relationships between the NMOS transistor integrated on each of the integration component IM12 to the integration component IM1K, and a corresponding first switch, a corresponding second switch, and the corresponding load impedance are similar to coupling relationships between the NMOS11, and the switch S21, the switch S31, and the load impedance ZL11. Details are not described in this embodiment of this application. In addition, OUT in FIG. 24 also represents the output end of the power subunit A10, and Iₐₘₚ also represents the feeding current of the power subunit A10.

Further, the power subunit A10 may further include P direct current blocking capacitors and P bias inductors. It should be noted that only a direct current blocking capacitor C31 and a bias inductor L31 that are coupled to the gate g of the NMOS 11 are marked in FIG. 25.

Refer to FIG. 25. One end of the direct current blocking capacitor C31 is coupled to the signal source IN, and the other end of the direct current blocking capacitor C31 is coupled to the gate g of the NMOS11. One end of the bias inductor L31 is coupled to the bias unit A23 (refer to FIG. 8, where one end of the bias inductor L31 may be coupled to the gate g (which may be considered as the output end of the bias unit A23) of the NMOS transistor in the bias unit A23), and the other end of the bias inductor L31 is coupled to the gate g of the NMOS11. The direct current blocking capacitor C31, the bias inductor L31, and the NMOS11 are integrally disposed on the integration component IM11. It should be noted that coupling relationships between the NMOS transistor integrated on each of the integration component IM12 to the integration component IM1P, and a corresponding direct current blocking capacitor and a corresponding bias inductor are similar to coupling relationships between the NMOS11, and the direct current blocking capacitor C31 and the bias inductor L31. Details are not described in this embodiment of this application.

In a possible implementation, when a power circuit needs to modulate a current signal (that is, the modulation signal), a current source unit, a bias unit, and a power module may be combined to obtain the power circuit configured to modulate the current signal.

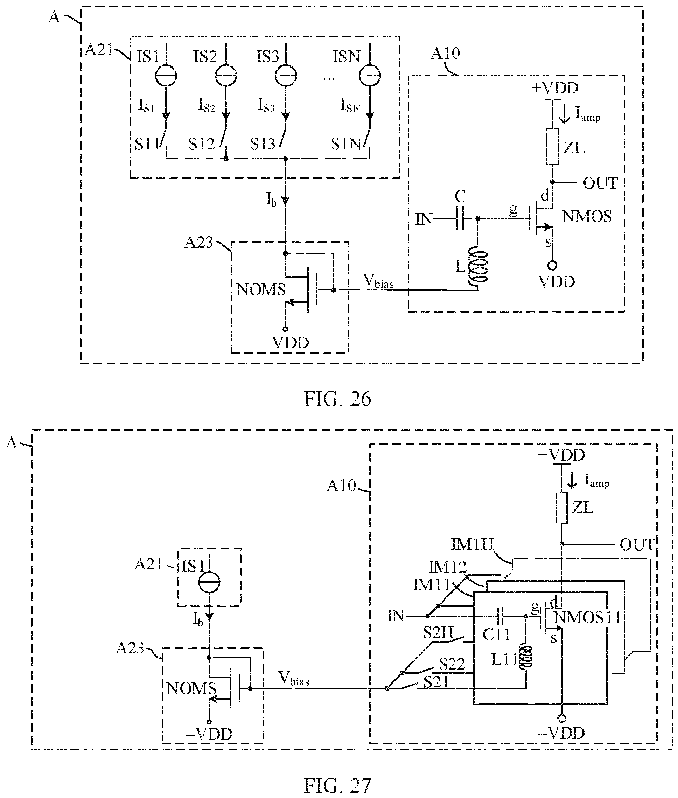

For example, the power circuit A shown in FIG. 26 may be obtained with reference to FIG. 3, FIG. 8, and FIG. 15. The feeding current I_{b1} that slowly increases of the power feeding module A2 may be obtained by using the N current sources (that is, the current source IS1, the current source IS2, the current source IS3, ..., and the current source ISN) and the N switches (that is, the switch S11, the switch S12, the switch S13, ..., and the switch S1N) in the current source unit A21 (where an example in which the power feeding subunit A20 includes one current source unit A21 is used). The NMOS in the bias unit A23 outputs the feeding voltage V_{bias} that slowly increases based on the feeding current I_{b1} that slowly increases. The NMOS in the power subunit A10 (where an example in which the power module A1 includes one power subunit A10 is used) controls, based on the feeding voltage V_{bias} that slowly increases, the static operating current Iₐₘₚ of the power subunit A10 to gradually increase. This avoids impact of the power circuit at a switch-on moment of the power circuit on a power supply, reduces a fluctuation of a power supply voltage +VDD, and improves stability of the power supply. In addition, this improves reliability of the power circuit, reduces a size of the power circuit, and reduces costs of the power circuit.

For another example, the power circuit A shown in FIG. 27 may be obtained with reference to FIG. 6, FIG. 8, and FIG. 19. The feeding current I_{b1} that slowly increases may be obtained by using one current source (that is, the current source IS1) in the current source unit A21 (where the example in which the power feeding subunit A20 includes one current source unit A21 is used). The NMOS in the bias unit A23 outputs the feeding voltage V_{bias} that slowly increases based on the feeding current I_{b1} that slowly increases. The NMOS (for example, the NMOS11) on the integration component IM11 to the integration component IM1H of the power subunit A10 (where the example in which the power module A1 includes one power subunit A10 is used) controls, based on the feeding voltage V_{bias} that slowly increases, the static operating current Iₐₘₚ to gradually increase. This avoids impact of the power module at the switch-on moment of the power circuit on the power supply, reduces the fluctuation of the power supply voltage +VDD, and improves the stability of the power supply. In addition, this improves the reliability of the power circuit, reduces the size of the power circuit, and reduces the costs of the power circuit.

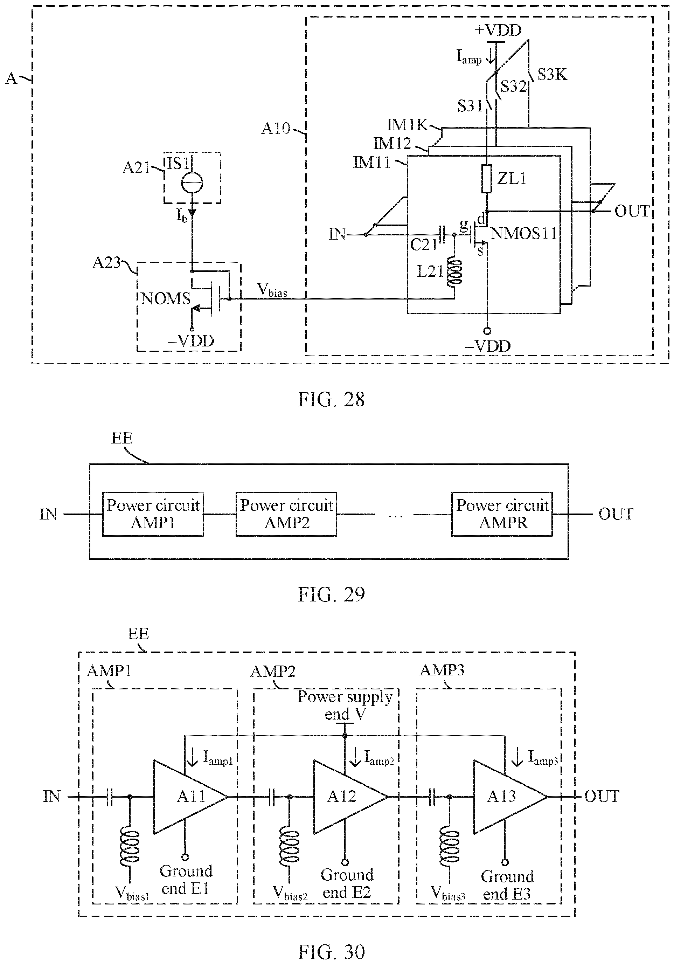

For another example, the power circuit A shown in FIG. 28 may be obtained with reference to FIG. 6, FIG. 8, and FIG. 23. The feeding current I_{b1} that slowly increases may be obtained by using one current source (that is, the current source IS1) in the current source unit A21 (where the example in which the power feeding subunit A20 includes one current source unit A21 is used). The NMOS in the bias unit A23 outputs the feeding voltage V_{bias} that slowly increases based on the feeding current I_{b1} that slowly increases. Based on the feeding voltage V_{bias} that slowly increases, the NMOS (for example, the NMOS11) on the integration component IM11 to the integration component IM1H of the power subunit A10 (where the example in which the power module A1 includes one power subunit A10 is used), and the switch S31 to the switch S3K in the power subunit A10 control the static operating current Iₐₘₚ to gradually increase. This avoids impact of the power module at the switch-on moment of the power circuit on the power supply, reduces the fluctuation of the power supply +VDD, and improves the stability of the power supply. The power circuit shown in FIG. 28 has a same function as the power circuit shown in FIG. 27: high reliability, a small size, and low costs.

It should be noted that in addition to the power circuits shown in FIG. 26 to FIG. 28, a power circuit in another structural form may further be obtained with reference to FIG. 3, FIG. 8, and FIG. 19, or with reference to FIG. 3, FIG. 8, and FIG. 23. A structural form of the power circuit is not limited in this embodiment of this application.

In another possible implementation, when a power circuit needs to modulate a voltage signal (that is, the modulation signal), a voltage source unit (for example, the voltage source in FIG. 10) and a power module (for example, any power module in FIG. 11 to FIG. 25) may be combined to obtain the power circuit.

In another possible implementation, an embodiment of this application further provides an electronic device EE (which may be referred to as a multi-stage power circuit), as shown in FIG. 29. In FIG. 29, the electronic device EE includes R power circuits (that is, a power circuit AMP1, a power circuit AMP2, ..., and a power circuit AMPR in FIG. 29). The R power circuits are connected in series. In other words, the R power circuits are coupled in a cascade manner.

For example, as shown in FIG. 30, the electronic device EE includes three power circuits in total: the power circuit AMP1, the power circuit AMP2, and a power circuit AMP3. The power circuit AMP1, the power circuit AMP2, and the power circuit AMP3 are coupled in a series manner (that is, the cascade manner). The power circuit AMP1 includes a power module A11 (refer to the foregoing descriptions of the power subunit A10), a current source unit (which is not shown in FIG. 30, and refer to the foregoing descriptions of the current source unit A21) that provides a feeding current for the power module A11, and a bias unit (which is not shown in FIG. 30, and refer to the foregoing descriptions of the bias unit A23) that outputs a feeding voltage V_{bias1} based on the feeding current. The power circuit AMP2 includes a power module A12 (refer to the foregoing descriptions of the power subunit A10), a current source unit (which is not shown in FIG. 30, and refer to the foregoing descriptions of the current source unit A21) that provides a feeding current for the power module A12, and a bias unit (which is not shown in FIG. 30, and refer to the foregoing descriptions of the bias unit A23) that outputs a feeding voltage V_{bias2} based on the feeding current. Similar to the power circuit AMP1 and the power circuit AMP2, the power circuit AMP3 includes a power module A13 (refer to the foregoing descriptions of the power subunit A10), a current source unit (which is not shown in FIG. 30, and refer to the foregoing descriptions of the bias unit A23) that provides a feeding current for the power module A13, and a bias unit (which is not shown in FIG. 30, and refer to the foregoing descriptions of the bias unit A23) that outputs a feeding voltage V_{bias3} based on the feeding current.

It should be noted that the power module A11 to the power module A13 each include a power transistor (where an NMOS transistor is used as an example). It may be understood that a drain of the NMOS transistor of the power module A11, a drain of the NMOS transistor of the power module A12, and a drain of the NMOS transistor of the power module A13 may be coupled to same +VDD (for example, a power supply end V in FIG. 30), or may be separately coupled to respective corresponding +VDD. A source of the NMOS transistor of the power module A11, a source of the NMOS transistor of the power module A12, and a source of the NMOS transistor of the power module A13 are separately connected to a respective corresponding ground end (for example, a ground end E1, a ground end E2, and a ground end E3 in FIG. 30).

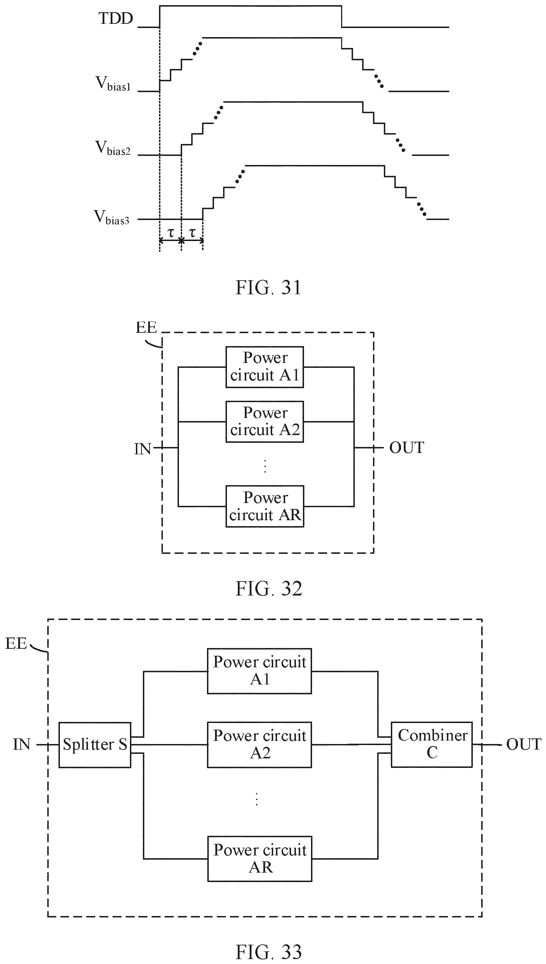

It may be further understood that when the electronic device EE receives a control signal, for example, a TDD signal, a static operating current that slowly increases of the power module A11 may be obtained by using the current source unit of the power circuit AMP1 in FIG. 30. Based on the static operating current that slowly increases of the power module A11, the feeding voltage V_{bias1} that slowly increases is obtained by using the bias unit of the power circuit AMP1 in FIG. 30. Similarly, the feeding voltage V_{bias2} that slowly increases may be obtained by using the current source unit and the bias unit of the power circuit AMP2 in FIG. 30, or the feeding voltage V_{bias3} that slowly increases may be obtained by using the current source unit and the bias unit of the power circuit AMP3 in FIG. 30. Based on obtaining of the feeding voltage V_{bias1}, the feeding voltage V_{bias2}, and the feeding voltage V_{bias3} that slowly increase, delay intervals (that is, τ in a schematic diagram of a timing of the TDD signal, the feeding voltage V_{bias1}, the feeding voltage V_{bias2}, and the feeding voltage V_{bias3} shown in FIG. 31, and certainly, a delay interval between the feeding voltage V_{bias1} and the feeding voltage V_{bias2} and a delay interval between the feeding voltage V_{bias2} and the feeding voltage V_{bias3} may be different) may be set between the power circuit AMP1 and the power circuit AMP2, and between the power circuit AMP2 and the power circuit AMP3 (that is, between stages) by using the delay interval set by the delay unit (refer to FIG. 5), further to reduce impact of the electronic device EE on the power supply end V and improve stability of the power supply end V

The electronic device EE provided in FIG. 30 may amplify a modulation signal (which may be a monophonic signal or a high-frequency alternate current signal, for example, a high-frequency amplitude signal or a high-frequency phase signal) from the signal source IN by using the multi-stage power circuit (that is, the power circuit AMP1 to the power circuit AMP3 in FIG. 30), to obtain an amplified modulation signal. This avoids impact of the electronic device EE at a switch-on moment of the electronic device EE on a same power supply (that is, the power supply end V in FIG. 30). The electronic device EE has high reliability, a small size, and low costs.

In another possible implementation, an embodiment of this application further provides an electronic device EE (which may be referred to as a multiple-channel power circuit). The electronic device EE includes R power circuits (that is, a power circuit AMP1, a power circuit AMP2, ..., and a power circuit AMPR in FIG. 32). The R power circuits are coupled in a parallel manner. In FIG. 32, IN represents a signal source of the electronic device EE, and OUT represents an output end of the electronic device EE.

Based on FIG. 32, the electronic device EE may further include a splitter S and a combiner C, as shown in FIG. 33. In FIG. 33, the electronic device EE includes the splitter S, R power circuits (that is, the power circuit AMP1, the power circuit AMP2, ..., and the power circuit AMPR in FIG. 33), and the combiner C. The R power circuits are coupled in the parallel manner. The splitter S divides the modulation signal from the signal source IN into N channels. N channels of modulation signals respectively enter the power circuit AMP1, the power circuit AMP2, ..., and the power circuit AMPR. The combiner C combines respective output signals from the power circuit AMP1, the power circuit AMP2, ..., and the power circuit AMPR, to obtain a signal output by the output end OUT of the electronic device EE.

If the electronic device EE shown in FIG. 32 and FIG. 33 is used for power amplification (where in other words, the signal source IN in FIG. 32 and FIG. 33 inputs power, and the output end OUT in FIG. 32 and FIG. 33 outputs power), it may be considered that the R power circuits in FIG. 32 and FIG. 33 are coupled in a power combination manner.

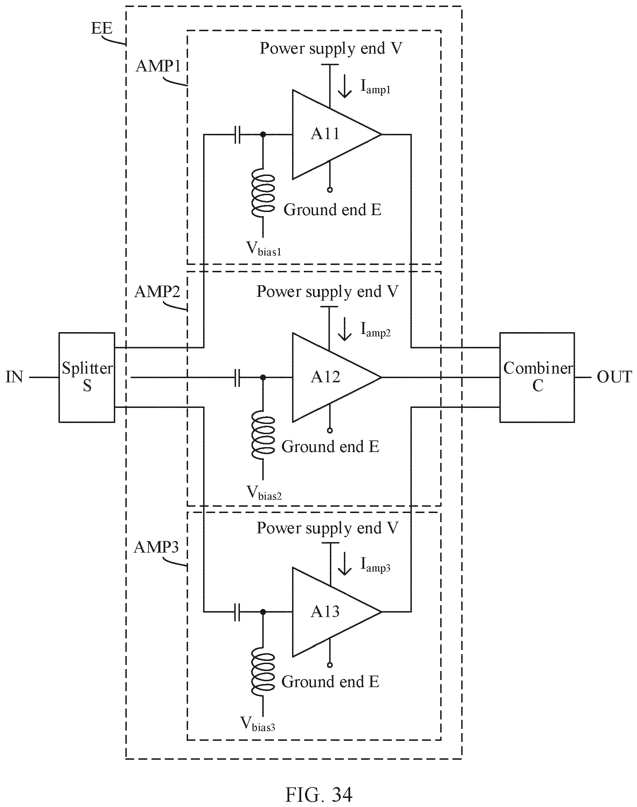

For example, as shown in FIG. 34, an electronic device EE includes three power circuits in total: a power circuit AMP1, a power circuit AMP2, and a power circuit AMP3. The power circuit AMP1, the power circuit AMP2, and the power circuit AMP3 are coupled in a parallel manner. The power circuit AMP 1 includes a power module A11 (refer to the foregoing descriptions of the power subunit A10), a current source unit (which is not shown in FIG. 34, and refer to the foregoing descriptions of the current source unit A21) that provides a feeding current for the power module A11, and a bias unit (which is not shown in FIG. 34, and refer to the foregoing descriptions of the bias unit A23) that outputs a feeding voltage V_{bias1} based on the feeding current. The power circuit AMP2 includes a power module A12 (refer to the foregoing descriptions of the power subunit A10), a current source unit (which is not shown in FIG. 34, and refer to the foregoing descriptions of the current source unit A21) that provides a feeding current for the power module A12, and a bias unit (which is not shown in FIG. 34, and refer to the foregoing descriptions of the bias unit A23) that outputs a feeding voltage V_{bias2} based on the feeding current. Similar to the power circuit AMP1 and the power circuit AMP2, the power circuit AMP3 includes a power module A13 (refer to the foregoing descriptions of the power subunit A10), a current source unit (which is not shown in FIG. 34, and refer to the foregoing descriptions of the bias unit A23) that provides a feeding current for the power module A13, and a bias unit (which is not shown in FIG. 34, and refer to the foregoing descriptions of the bias unit A23) that outputs a feeding voltage V_{bias3} based on the feeding current.

It should be noted that the power module A11 to the power module A13 each include a power transistor (where an NMOS transistor is used as an example). It may be understood that a drain of the NMOS transistor of the power module A11, a drain of the NMOS transistor of the power module A12, and a drain of the NMOS transistor of the power module A13 may be separately coupled to respective corresponding +VDD (that is, a power supply end V in FIG. 34) (where it may be understood that the drain of the NMOS transistor of the power module A11, the drain of the NMOS transistor of the power module A12, and the drain of the NMOS transistor of the power module A13 may be coupled to the respective corresponding +VDD by using respective corresponding load impedances), or may be coupled to a same power supply end V A source of the NMOS transistor of the power module A11, a source of the NMOS transistor of the power module A12, and a source of the NMOS transistor of the power module A13 are separately connected to a respective corresponding ground end (a ground end E1, a ground end E2, and a ground end E3 in FIG. 34).

It may be further understood that when the electronic device EE receives a control signal, for example, a TDD signal, the feeding current that slowly increases may be obtained by using the current source unit of the power circuit AMP1 in FIG. 34. Based on the feeding current that slowly increases, the feeding voltage V_{bias1} that slowly increases is obtained by using the current source unit and the bias unit of the power circuit AMP1 in FIG. 34. Similarly, the feeding voltage V_{bias2} that slowly increases may be obtained by using the current source unit and the bias unit of the power circuit AMP2 in FIG. 34, or the feeding voltage V_{bias3} that slowly increases may be obtained by using the current source unit and the bias unit of the power circuit AMP3 in FIG. 34. Based on obtaining of the feeding voltage V_{bias1}, the feeding voltage V_{bias2}, and the feeding voltage V_{bias} that slowly increase, delay intervals (For a timing of the time division duplex TDD signal, the feeding voltage V_{bias1}, the feeding voltage V_{bias2}, and the feeding voltage V_{bias3}, refer to FIG. 31, and the delay interval is τ in FIG. 31) may be set between the power circuit AMP1 and the power circuit AMP2 and between the power circuit AMP2 and the power circuit AMP3 (that is, between channels) by using the delay interval set by the delay unit (refer to FIG. 6), further to reduce impact of the electronic device EE on the power supply end V, reduce a voltage fluctuation of the power supply end V, and improve stability of the power supply end V

The electronic device EE provided in FIG. 34 may amplify a modulation signal (which may be a monophonic signal or a high-frequency alternate current signal, for example, a high-frequency amplitude signal or a high-frequency phase signal) from a signal source IN by using a multiple-channel power circuit (that is, the power circuit AMP 1 to the power circuit AMP3 in FIG. 34), to obtain an amplified modulation signal. This avoids impact of an amplifier circuit at a switch-on moment of the electronic device EE on different power supplies (that is, a plurality of power supply ends V in FIG. 34). The multiple-channel electronic device EE has high reliability, a small size, and low costs.

It should be understood that in various embodiments of this application, sequence numbers of the foregoing processes do not mean execution sequences. The execution sequences of the processes should be determined based on functions and internal logic of the processes, and should not constitute any limitation on the implementation processes of embodiments of this application.

A person skilled in the art may be aware that units and algorithm steps in the examples described with reference to the embodiments disclosed in this specification can be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in another manner. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or another form.

The units described as separate parts may or may not be physically separate, and components displayed as units may or may not be physical units, may be located in one position, or may be distributed on a plurality of network units. A part of or all of the units may be selected based on actual requirements to achieve the objectives of the solutions of embodiments.

In addition, functional units in embodiments of this application may be integrated into one processing unit, each of the units may exist independently physically, or two or more units may be integrated into one unit.

When the functions are implemented in a form of a software functional unit and sold or used as an independent product, the functions may be stored in one computer-readable storage medium. Based on such an understanding, the technical solutions of this application essentially, or a part contributing to the conventional technology, or a part of the technical solutions may be embodied in a form of a software product. The computer software product is stored in one storage medium, and includes several instructions for enabling a computer device (which may be a personal computer, a server, a network device, or the like) to perform all or a part of the steps of the methods described in embodiments of this application. The foregoing storage medium includes a medium that may store program code, for example, a USB flash drive, a removable hard disk, a read-only memory (Read-Only Memory, ROM), a random access memory (Random Access Memory, RAM), a magnetic disk, or a compact disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power amplifier circuit, comprising a power amplifier module and a power feeding module coupled to the power amplifier module, wherein
the power amplifier module is configured to supply power in a time-slice power-on manner; and
the power feeding module comprises a plurality of power feeding subunits, the plurality of power feeding subunits are coupled to respective control signal cables, a delay unit is coupled between the control signal cables, and the control signal cable is configured to control the power feeding module to supply power to the power amplifier module in the time-slice power-on manner based on a delay set by the delay unit.

2. The power amplifier circuit according to claim 1, wherein the power amplifier module comprises a plurality of power subunits, and
the power feeding module is configured to supply power to the plurality of power subunits in the time-slice power-on manner.

3. The power amplifier circuit according to claim 1 or 2, wherein the power feeding subunit comprises a current source unit and a switch unit, wherein
the current source unit comprises a plurality of current sources, the switch unit comprises a plurality of switches, the plurality of current sources are coupled to the plurality of switches in one-to-one correspondence; and
the plurality of switches are configured to control, based on a control signal provided by the control signal cable, the plurality of current sources to supply power to the power amplifier module.

4. The power amplifier circuit according to any one of claims 1 to 3, wherein the power feeding subunit comprises a voltage source unit, wherein the voltage source unit comprises one voltage source; and
the voltage source is configured to supply power to the power amplifier module based on the control signal provided by the control signal cable.

5. The power amplifier circuit according to any one of claims 1 to 4, wherein the power feeding module further comprises a bias unit, wherein an input end of the bias unit is coupled to output ends of the plurality of power feeding subunits, and an output end of the bias unit is coupled to an input end of the power amplifier module;
the power feeding subunit is further configured to supply a feeding current to the bias unit; and
the bias unit is configured to provide a feeding voltage for the power amplifier module based on the feeding current.

6. The power amplifier circuit according to claim 2, wherein the power subunit comprises one power transistor and one load impedance, wherein
a control electrode of the power transistor is coupled to an output end of the power feeding module, a first electrode of the power transistor is coupled to a power supply end by using the load impedance, and a second electrode of the power transistor is coupled to a ground end.

7. The power amplifier circuit according to claim 6, wherein the power transistor is a transistor, wherein
a base of the transistor is coupled to the output end of the power feeding module, a collector of the transistor is coupled to the power supply end by using the load impedance, and an emitter of the transistor is coupled to the ground end.

8. The power amplifier circuit according to claim 6, wherein the power transistor is a field effect transistor, wherein
a gate of the field effect transistor is coupled to the output end of the power feeding module, a drain of the field effect transistor is coupled to the power supply end by using the load impedance, and a source of the field effect transistor is coupled to the ground end.

9. The power amplifier circuit according to claim 2, wherein the power subunit comprises a plurality of power transistors, a plurality of first switches, and a load impedance, wherein the plurality of power transistors and the plurality of first switches are in one-to-one correspondence; and
a control electrode of the power transistor is coupled to an output end of the power feeding module by using a corresponding first switch, a first electrode of the power transistor is coupled to a power supply end by using the load impedance, and a second electrode of the power transistor is coupled to a ground end.

10. The power amplifier circuit according to claim 9, wherein the power transistor is a transistor, wherein
a base of the transistor is coupled to the output end of the power feeding module by using a corresponding first switch, a collector of the transistor is coupled to the power supply end by using the load impedance, and an emitter of the transistor is coupled to the ground end.

11. The power amplifier circuit according to claim 9, wherein the power transistor is a field effect transistor, wherein
a gate of the field effect transistor is coupled to the output end of the power feeding module by using a corresponding first switch, a drain of the field effect transistor is coupled to the power supply end by using the load impedance, and a source of the field effect transistor is coupled to the ground end.

12. The power amplifier circuit according to claim 2, wherein the power subunit comprises a plurality of power transistors, a plurality of second switches, and a load impedance, wherein the plurality of power transistors and the plurality of second switches are in one-to-one correspondence; and
a control electrode of the power transistor is coupled to an output end of the power feeding module, a first electrode of the power transistor is coupled to a power supply end by using the load impedance and a corresponding second switch, and a second electrode of the power transistor is coupled to a ground end.

13. The power amplifier circuit according to claim 12, wherein the power transistor is a transistor, wherein
a base of the transistor is coupled to the output end of the power feeding module, a collector of the transistor is coupled to the power supply end by using the load impedance and a corresponding second switch, and an emitter of the transistor is coupled to the ground end.

14. The power amplifier circuit according to claim 12, wherein the power transistor is a field effect transistor, wherein
a gate of the field effect transistor is coupled to the output end of the power feeding module, a drain of the field effect transistor is coupled to the power supply end by using the load impedance and a corresponding second switch, and a source of the field effect transistor is coupled to the ground end.

15. The power amplifier circuit according to claim 2, wherein the power subunit comprises a plurality of power transistors, a plurality of first switches, a plurality of second switches, and a load impedance, wherein the plurality of power transistors are in one-to-one correspondence with the plurality of first switches and the plurality of second switches; and
a control electrode of the power transistor is coupled to an output end of the power feeding module by using a corresponding first switch, a first electrode of the power transistor is coupled to a power supply end by using the load impedance and a corresponding second switch, and a second electrode of the power transistor is coupled to a ground end.

16. The power amplifier circuit according to claim 15, wherein the power transistor is a transistor, wherein
a base of the transistor is coupled to the output end of the power feeding module by using a corresponding first switch, a collector of the transistor is coupled to the power supply end by using the load impedance and a corresponding second switch, and an emitter of the transistor is coupled to the ground end.

17. The power amplifier circuit according to claim 15, wherein the power transistor is a field effect transistor, wherein
a gate of the field effect transistor is coupled to the output end of the power feeding module by using a corresponding first switch, a drain of the field effect transistor is coupled to the power supply end by using the load impedance and a corresponding second switch, and a source of the field effect transistor is coupled to the ground end.

18. The power amplifier circuit according to any one of claims 6 to 8, wherein the power subunit further comprises one direct current blocking capacitor and one bias inductor, wherein
the direct current blocking capacitor is disposed between the control electrode of the power transistor and a connected signal source, and the bias inductor is disposed between the control electrode of the power transistor and the power feeding module.

19. The power amplifier circuit according to any one of claims 9 to 17, wherein the power subunit further comprises a plurality of direct current blocking capacitors and a plurality of bias inductors, wherein the plurality of direct current blocking capacitors, the plurality of bias inductors, and the plurality of power transistors are in one-to-one correspondence;
one end of the direct current blocking capacitor is coupled to a signal source, and the other end of the direct current blocking capacitor is coupled to the control electrode of the power transistor; and
one end of the bias inductor is coupled to the power feeding module, and the other end of the bias inductor is coupled to the control electrode of the power transistor.

20. The power amplifier circuit according to claim 5, wherein the bias unit comprises a transistor or a field effect transistor.

21. The power amplifier circuit according to any one of claims 1 to 20, wherein the power amplifier module is a power amplifier PA, configured to work in a transmit slot in a time division duplex TDD mode.

22. The power amplifier circuit according to any one of claims 1 to 20, wherein the power amplifier module is a low noise amplifier LNA, configured to work in a receive slot in a time division duplex TDD mode.

23. An electronic device, comprising a plurality of the power amplifier circuits according to any one of claims 1 to 22, wherein
the plurality of the power amplifier circuits are coupled in a series manner or in a parallel manner.

24. The electronic device according to claim 23, further comprising a circuit board, wherein
the power amplifier circuit is disposed on the circuit board.
